# FASCICULE DE BREVET EUROPEEN

(11) **EP 3 154 192 B1**
(45) Date de publication et mention de la délivrance du brevet: **25.11.2020**
(21) Numéro de dépôt: 16192738.9
(22) Date de dépôt: 07.10.2016
(51) Int. Cl.: H03F 1/02, H03F 3/189, H03F 3/24, H03F 3/60, H04B 1/74, H04B 7/185

(54) **ARCHITECTURE D'UN DISPOSITIF D'AMPLIFICATION REPARTIE LARGE BANDE**
ARCHITEKTUR EINER VERTEILTEN BREITBANDVERSTÄRKUNGSVORRICHTUNG
ARCHITECTURE OF A BROADBAND DISTRIBUTED AMPLIFICATION DEVICE

(30) Priorité: 09.10.2015 FR 1502128
(43) Date de publication de la demande: 12.04.2017
(73) Titulaire: Thales, 92400 Courbevoie (FR); Centre National d'Etudes Spatiales, 75039 Paris Cedex 01 (FR)
(72) Inventeur: GONZALEZ ESTEBAN, Eva Maria, 31037 TOULOUSE (FR); VOISIN, Philippe, 31037 TOULOUSE (FR); BRIAND, Aline, 31037 TOULOUSE (FR); ONILLON, Bertrand, 31037 TOULOUSE (FR); TAISANT, Jean-Philippe, 31401 TOULOUSE CEDEX 9 (FR)
(74) Mandataire: Marks & Clerk France

(56) Documents cités:
- EP-A1- 2 763 314
- US-A- 4 198 611
- US-A- 4 644 301
- US-A1- 2009 243 719
- DANESHMAND M ET AL: "RF MEMS Satellite Switch Matrices", IEEE MICROWAVE MAGAZINE, IEEESERVICE CENTER, PISCATAWAY, NJ, US, vol. 12, no. 5, 1 août 2011 (2011-08-01), pages 92-109, XP011370160, ISSN: 1527-3342, DOI: 10.1109/MMM.2011.941417

## Description

La présente invention concerne un dispositif d'amplification répartie large bande pour satellite, fonctionnant dans une bande de fréquences radioélectriques microondes.

Les applications de l'invention concernent les charges utiles de télécommunications, notamment celles qui requièrent la fourniture d'une puissance élevée à un seul faisceau, et plus particulièrement les charges utiles flexibles de télécommunications.

Dans ces applications, les opérateurs n'ayant pas toujours une visibilité très nette sur la répartition future du trafic (et donc de la puissance) sur les couvertures adressées ont besoin de disposer d'une certaine flexibilité permettant d'adapter le satellite pendant sa durée de vie aux besoins en trafic résultant de la demande et du succès de service sur différentes zones géographiques. Il est donc important de pouvoir router les canaux de manière flexible vers les faisceaux, c'est-à-dire de telle manière que le nombre total de canaux traités par la charge utile puisse être réparti vers les différents faisceaux conformément à la demande de trafic et ce pendant la durée de vie du satellite.

Afin d'assurer cette flexibilité, il est connu d'utiliser une amplification répartie dans laquelle tous les amplificateurs mis en parallèle amplifient tous les canaux d'entrée de la charge utile.

Selon cette architecture, les canaux sont combinés avant amplification, l'amplification est commune à tous les canaux et chaque amplificateur alimente tous les signaux des faisceaux. Cette architecture est compatible de l'amplification de n'importe quelle distribution fréquentielle des canaux.

L'article de P. Angeletti et al., intitulé « Multiport Power Amplifiers for Flexible Satellite Antennas and Payloads », publié dans le Microwave Journal de Mai 2010, décrit le principe général selon lequel l'architecture d'une charge utile de télécommunications, reconfigurable en temps réel pour répartir la puissance radiofréquence (RF) disponible en fonction de la demande, est fondée sur la possibilité d'exploiter un réservoir ou banque de puissance radioélectrique, formé par un ensemble d'amplificateurs disposés en parallèle, et qui met en œuvre une amplification distribuée d'un ou plusieurs signaux, chacun des signaux étant amplifié par tous les amplificateurs.

L'article de P. Angeletti décrit des exemples d'architectures illustrant ce principe général comme le répéteur de communications mobiles multifaisceaux du satellite japonais ETS-VI, les répéteurs de communications mobiles des satellites MTSAT-1 et MTSAT-2, et la charge utile de communications mobiles du satellite Inmarsat-3.

L'article de Hosoda I. et al., intitulé « Ka band high power multiport amplifier (MPA) configured with TWTA for WINDS satellite », IEEE 2007, décrit l'architecture d'une charge utile de télécommunication reconfigurable utilisant le principe d'une amplification répartie.

Si le principe d'une amplification répartie tel que décrit ci-dessus répond au problème d'adaptation en temps réel de la puissance RF disponible de la charge utile aux exigences de trafic, se posent les problèmes de la mise en parallèle d'amplificateurs sur une bande de transmission totale plus large que celles utilisées actuellement et la réalisation d'un schéma de redondance (amplificateurs de secours) compatible de cette contrainte large bande.

En effet, les systèmes classiques actuels opèrent sur des bandes relativement étroites. Par exemple, l'amplificateur multiport MPA (en anglais Multi-Port Amplifier) du satellite WINDS fonctionne en bande Ka avec 6% de la bande utile. Dans ces systèmes classiques, le réglage individuel des amplificateurs est typiquement effectué à la fréquence centrale de la bande à traiter, ce qui limite la correction sur toute la bande. Lorsqu'on cherche à augmenter la bande passante de transmission, la dispersion de gain et de phase augmente dans les bords de la bande, et elle dépasse la dispersion « acceptable » pour avoir une bonne recombinaison de la puissance.

Or, un fonctionnement d'un dispositif d'amplification répartie sur des bandes de transmission utile plus larges est souhaité, par exemple une bande utile de 2 GHz à la fréquence de 11,7 GHz pour la bande Ku.

La demande de brevet WO 2008/017699 A1 décrit une solution au problème ci-dessus en proposant une architecture dans laquelle un dispositif d'amplification répartie amplifie et répartit de manière flexible une pluralité de s canaux de transmission d'entrée vers une sortie correspondant à un faisceau d'antenne avec une performance acceptable du réglage en amplitude et en phase des amplificateurs sur une large bande de fréquences.

Le dispositif d'amplification répartie proposé comporte des moyens de combinaison des bandes de fréquences comprenant s entrées pour recevoir les s canaux de transmission et q sorties pour fournir respectivement les s canaux de transmission regroupés au sein de q bandes de fréquences, des moyens d'amplification de puissance incluant p amplificateurs actifs, disposés en parallèle pour l'amplification répartie des canaux, et des moyens de réglage du gain et de la phase associés aux p amplificateurs de puissance sur les q bandes de fréquences.

Toutefois, même si cette architecture permet un alignement en gain et phase entre amplificateurs sur une large bande de fréquence large et ainsi l'utilisation d'amplificateurs mis en parallèle dans des applications multicanaux de charges utiles flexibles, la répartition des canaux de transmission selon les q bandes de fréquences et l'utilisation de p amplificateurs actifs induit la nécessité d'utiliser q*p déphaseurs/ atténuateurs, ce qui conduit à une solution plus complexe du fait de l'utilisation de déphaseurs et atténuateurs commandables.

De plus, l'architecture proposée décrit des réglages effectués en amont de l'ensemble de huit amplificateurs considérés a priori comme des amplificateurs nominaux et donc les réglages d'une unique configuration de routage nominale. Le document WO 2008/017699 A1 ne décrit pas la prise en compte pour les réglages des moyens de réglage en gain et phase des effets induits par des reconfigurations du routage qui mettent en œuvre des configurations de secours faisant intervenir un ou plusieurs amplificateurs de secours.

Les effets induits par un passage sur les amplificateurs de secours sont causés notamment par l'introduction de disparités de longueurs électriques entre les chemins d'amplification active créées lors de la reconfiguration par des anneaux de redondance d'entrée et de sortie, et ces effets viennent augmenter la dispersion en gain et phase des voies d'amplification actives, d'autant plus que la largeur de la bande totale utile de transmission augmente. Les documents EP2763314 A1 et DANESHMAND M ET AL, "RF MEMS Satellite Switch Matrices",IEEE MICROWAVE MAGAZINE, IEEESERVICE CENTER, PISCATAWAY, NJ, US, vol. 12, no. 5, 1 août 2011 (2011-08-01), pages 92-109, décrivent un exemple de dispositif d'amplification répartie redondé.

Ainsi, pour toutes les architectures des dispositifs d'amplification répartis redondés connus à ce jour, lorsqu'on cherche à étendre la bande utile de transmission pour atteindre une large bande d'utilisation du réservoir dans le respect d'une dispersion en gain et phase acceptable des voies d'amplification actives d'une même configuration, une égalisation en amplitude et en phase desdites voies ou chemins d'amplification du réservoir par des moyens de réglage en gain et phase classiques sur l'ensemble des configurations de fonctionnement nominale et de secours du réservoir ne permet pas une telle extension large bande.

Un premier problème technique est de proposer une architecture d'un dispositif d'amplification répartie redondée qui diminue sur une large bande la dispersion en gain et phase des voies d'amplification actives d'une même configuration.

Un deuxième problème technique, connexe au premier problème, est de proposer un dispositif d'amplification répartie redondé qui permette avec une performance suffisante en terme de dispersion acceptable d'égaliser en amplitude et en phase sur une large bande les chemins internes d'amplification actives de toutes les configurations de fonctionnement du dispositif.

A cet effet, l'invention a pour objet un dispositif d'amplification répartie selon la revendication 1, destiné à une charge utile de communications d'un satellite, comprenant un réservoir d'amplification répartie pour amplifier une première pluralité d'un premier nombre entier p supérieur ou égal à 2 de signaux radioélectriques (RF) d'entrée à amplifier, reçus par un premier port d'entrée de bornes d'entrée, identiques entre eux à une phase près et déphasés entre eux suivant une loi de phase prédéterminée, en une deuxième pluralité de p signaux RF amplifiés fournis par un deuxième port de sortie de bornes de sortie, associées respectivement aux bornes d'entrée du premier port selon le même ordre, le réservoir d'amplification répartie comportant :
.- un ensemble d'un deuxième nombre entier n, supérieur à p et inférieur ou égal à 2p+1, d'amplificateurs disposés électriquement en parallèle et formant respectivement des voies internes d'amplification, mutuellement isolées électro-magnétiquement et égalisées, respectivement numérotées par un indice de ligne variant de 1 au deuxième nombre entier n, l'ensemble des n amplificateurs étant composé d'une première série de p amplificateurs radiofréquence nominaux et d'une deuxième série de n-p amplificateurs de secours,
.- un anneau de redondance d'entrée, formé par un premier réseau de commutateurs tournants quadripolaires, et un anneau de redondance de sortie, formé par un deuxième réseau de commutateurs tournants quadripolaires, les anneaux de redondance d'entrée et de sortie étant connectés respectivement entre le premier port d'entrée et un troisième port de bornes d'entrée de l'ensemble des n amplificateurs et entre un quatrième port de bornes de sortie de l'ensemble des n amplificateurs et le deuxième port de sortie, pour mettre en œuvre une famille de configurations de routage comportant une configuration de routage nominale qui utilise les p amplificateurs nominaux de la première série comme amplificateurs actifs, et une ou plusieurs configurations de routage de secours qui utilisent chacune au moins un des n-p amplificateurs de secours parmi les p amplificateurs actifs sélectionnés dans l'ensemble des n amplificateurs; le dispositif d'amplification répartie étant caractérisé en ce que :
.- les anneaux de redondance d'entrée et de sortie utilisent des conditions de propagation analogues ; et
.- les anneaux de redondance d'entrée et de sortie sont topologiquement et géométriquement configurés de sorte que chaque configuration de routage de la famille comporte un ensemble de p chemins indépendants d'amplification répartie, chaque chemin d'amplification incluant individuellement une borne d'entrée du premier port, la borne de sortie du deuxième port associée à la borne d'entrée du premier, un amplificateur actif et son numéro de ligne, des premières liaisons passives connectées en série et traversant au moins trois commutateurs tournants de l'anneau de redondance d'entrée et reliant la borne d'entrée du premier port à la borne d'entrée de l'amplificateur actif, et des deuxièmes liaisons passives connectées en série et traversant au moins un commutateur de l'anneau de redondance de sortie et reliant la borne de sortie de l'amplificateur actif à la borne de sortie du deuxième port ; et les longueurs électriques de tous les chemins d'une même configuration de routage de la famille sont égales.

Suivant des modes particuliers de réalisation, le dispositif d'amplification répartie comprend l'une ou plusieurs des caractéristiques suivantes :
.- les anneaux de redondance d'entrée et de sortie sont topo-logiquement et géométriquement configurés et la famille des configurations de routage est choisie de sorte que les longueurs électriques de tous les chemins de toute la famille sont égales ;
.- lors d'une reconfiguration d'une première configuration de routage de la famille en une deuxième configuration de routage de la famille, les différences de longueurs électriques issues de la reconfiguration de l'anneau d'entrée sont compensées par la reconfiguration de l'anneau de redondance de sortie pour chaque chemin d'amplification répartie modifié ;
.- la même technologie est partagée par les anneaux de redondance d'entrée et de sortie, et est comprise dans l'ensemble formé par la technologie coaxiale, la technologie des guides d'onde ;
.- indépendamment de tous les chemins de toutes les configurations de routage de la famille du réservoir, les commutateurs tournants d'un même chemin d'amplification sont traversés globalement de la même façon en termes du nombre de commutateurs tournants traversés d'un même chemin et de la répartition numérique des configurations de commutation des commutateurs tournant activées dans ce chemin ;
.- la famille des configurations de routage comporte une configuration de routage nominale qui utilise les p amplificateurs nominaux de la première série comme amplificateurs actifs, et une ou plusieurs configurations de routage de secours qui utilisent chacune au moins un des n-p amplificateurs de secours parmi les p amplificateurs actifs sélectionnés dans l'ensemble des n amplificateurs; la ou les configurations de routage de secours étant déterminées pour maintenir une capacité maximale d'amplification du réservoir dans tous les cas de pannes d'au plus p amplificateurs parmi l'ensemble des n amplificateurs lorsque p est inférieur ou égal à n, et d'au plus p+1 amplificateurs parmi l'ensemble des n amplificateurs lorsque n est égal à 2p+1.
.- le premier réseau des commutateurs interconnectés de l'anneau de redondance d'entrée est agencé suivant une première matrice dont les éléments sont les commutateurs tournants quadripolaires d'entrée et forment des premiers nœuds arrangés suivant au moins deux colonnes et n lignes, les lignes correspondant aux lignes des voies internes d'amplification, p premiers nœuds d'extrémité amont d'une première colonne d'extrémité amont étant connectés aux bornes d'entrée du premier port et p+r premiers nœuds d'extrémité aval d'une première colonne d'extrémité avale, étant connectés respectivement un à une aux bornes d'entrée des p+r amplificateurs ; et le deuxième réseau des commutateurs interconnectés de l'anneau de redondance de sortie est agencé suivant une deuxième matrice dont les éléments sont les commutateurs tournants de sortie et forment des deuxièmes nœuds arrangés suivant au moins une colonne et n lignes, les n lignes correspondant aux lignes des voies internes d'amplification avec la même numérotation, p deuxièmes nœuds nominaux d'extrémité aval d'une deuxième colonne d'extrémité aval étant connectés aux bornes de sortie du deuxième port et p+r deuxièmes nœuds d'extrémité amont d'une deuxième colonne d'extrémité amont, étant connectés en amont respectivement aux bornes de sortie des amplificateurs suivant un même rang i, lorsque la deuxième matrice comporte au moins deux deuxièmes colonnes ; ou p deuxièmes nœuds d'extrémité aval et amont d'une unique deuxième colonne d'extrémité connectés en aval aux bornes de sortie du deuxième port et connectés en amont respectivement aux bornes de sortie des amplificateurs nominaux suivant un même rang i, et r deuxièmes nœuds restant d'extrémité amont connectés en amont respectivement aux bornes de sortie des amplificateurs lorsque la deuxième matrice comporte une unique deuxième colonne ;
.- au moins un commutateur parmi les commutateurs de la première colonne d'extrémité amont et de la deuxième colonne d'extrémité amont est remplacé par une liaison de même longueur électrique ;
.- la première matrice comporte deux ou trois colonnes et la deuxième matrice comporte une unique colonne ;
.- le réservoir d'amplification répartie comporte des moyens de réglage en amplitude et phase, disposés en amont et/ou en aval de chaque amplificateurs entre les anneaux de redondance d'entrée et de sortie, de préférence en amont lorsque les amplificateurs sont des amplificateurs de puissance et de préférence en aval lorsque les amplificateurs sont des amplificateurs à faible bruit ; et les moyens de réglage en amplitude et phase sont configurés pour équilibrer tous les chemins internes d'amplification répartie des configurations de fonctionnement prévues du réservoir dans une large bande de fréquences ;
.- les moyens de réglage en amplitude et phase de chaque chemin interne d'amplification répartie comprennent un atténuateur d'amplitude, un premier déphaseur et un deuxième déphaseur, le premier déphaseur étant un déphaseur du type « longueur électrique » compris dans l'ensemble formé par les « phase trimmers », et le deuxième déphaseur étant un déphaseur à déphasage constant sur toute la bande large de fréquences ; et les atténuateurs d'amplitude, les premiers déphaseurs et les deuxièmes déphaseurs sont configurés respectivement pour équilibrer les gains des amplificateurs sur la large bande de fréquence, rapprocher les variations de phase en fonction de la fréquence sur une large bande de fréquence de tous les chemins internes d'amplification répartie des configurations de fonctionnement prévues du réservoir, compenser les dispersions des décalages de phases constants introduits par les amplificateurs actifs de tous les chemins internes d'amplification répartie des configurations de fonctionnement prévues du réservoir ;
.- les amplificateurs du réservoir sont des amplificateurs de puissance compris dans l'ensemble formé par les amplificateurs utilisant des tubes à ondes progressives (TWTAs) et les amplificateurs à état solide (SSPAs), et le dispositif d'amplification répartie est un amplificateur de puissance multiport comportant en outre un réseau d'équi-répartition de la puissance d'entrée sur les bornes d'entrée du port d'entrée; et un réseau de répartition de la puissance de sortie ;
.- le réseau répartiteur de puissance d'entrée est un réseau d'entrée de formation de faisceau et le réseau de répartition de puissance de sortie est un réseau de formation de sortie ;
.- les amplificateurs du réservoir d'amplification répartie sont des amplificateurs à état solide à faible bruit et l'étage de réception d'une antenne active de réception ;
.- le dispositif d'amplification décrit ci-dessus comprend en outre des moyens de combinaison de bandes de fréquences comportant n entrées pour recevoir n canaux de transmission et q sorties pour fournir respectivement des canaux regroupés au sein de q bandes de fréquences en q signaux de bandes de fréquences ; et un ensemble de diviseurs pour diviser en puissance les q signaux de bandes sur les p entrées du port d'entrée du réservoir d'amplification ; et des moyens de réglage du gain et de phase correspondant aux p amplificateurs sur les q bandes de fréquence ;
.- les moyens de réglage du gain et de la phase comportent p fois q déphaseurs et atténuateurs disposés au sein de l'ensemble de diviseurs.

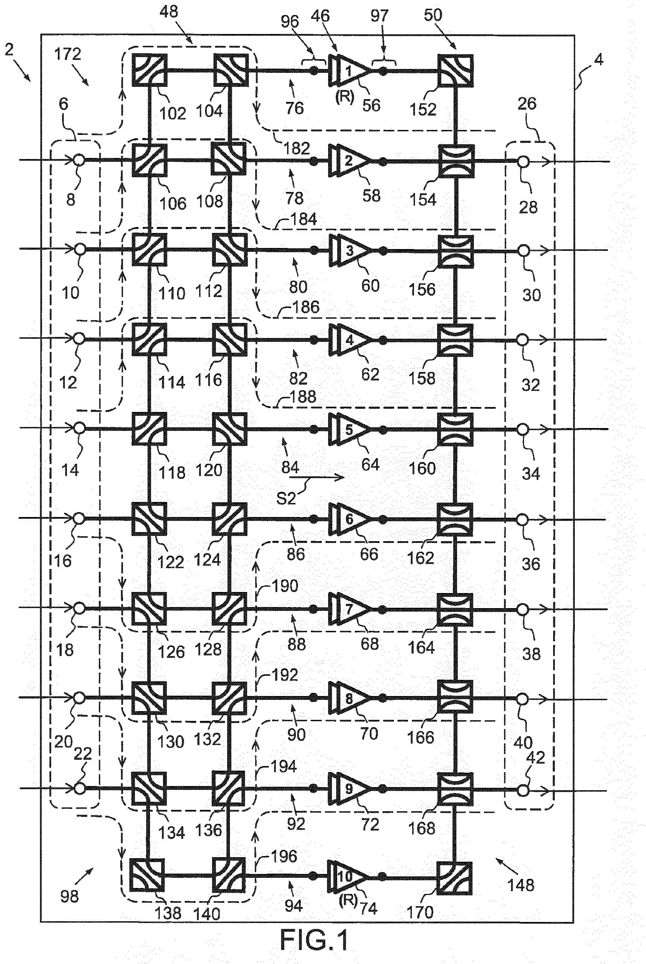

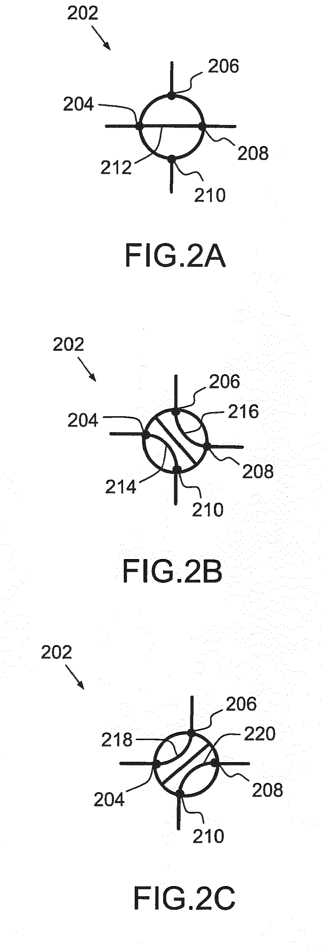

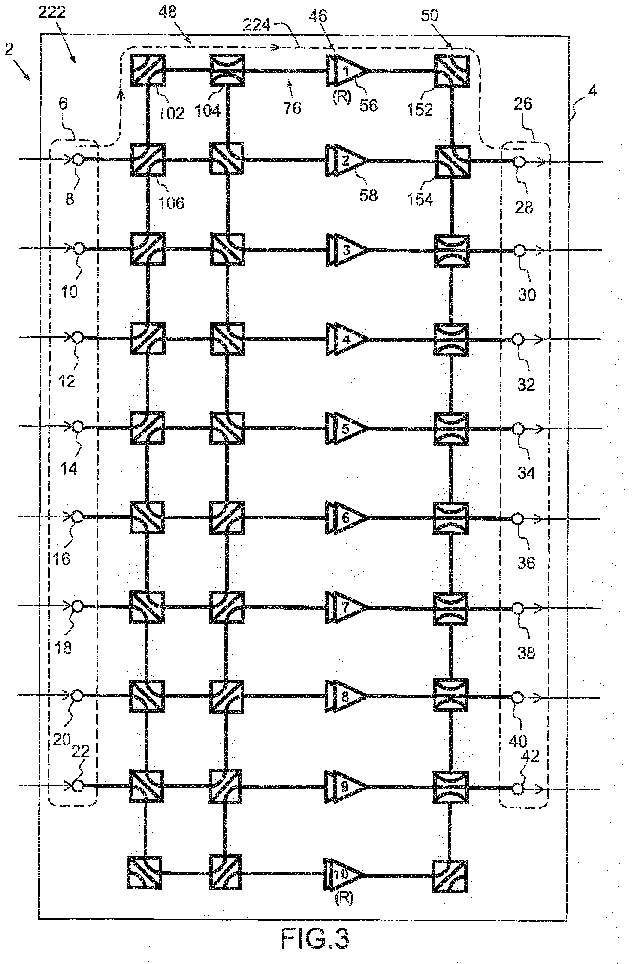

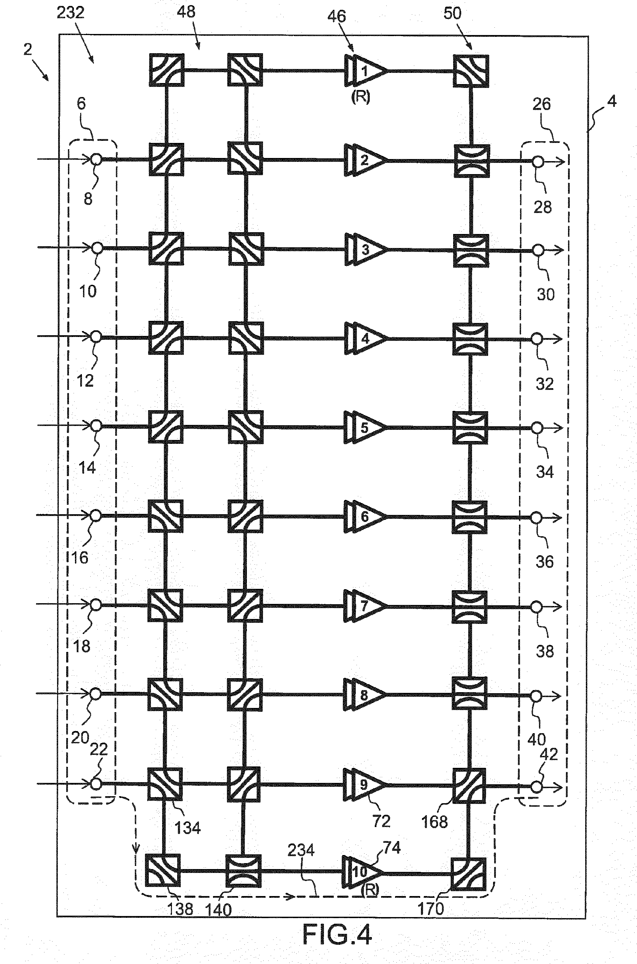

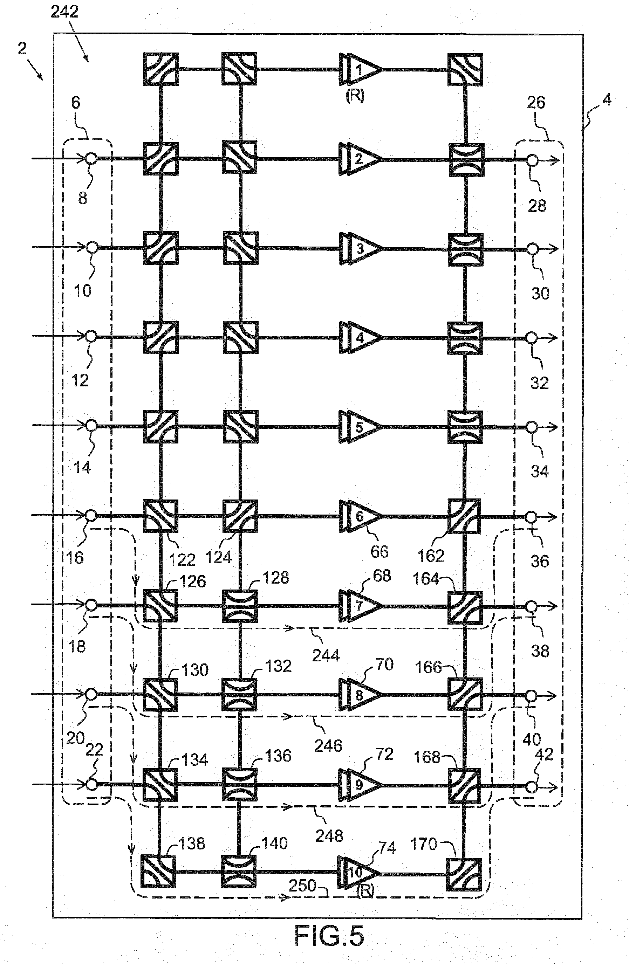

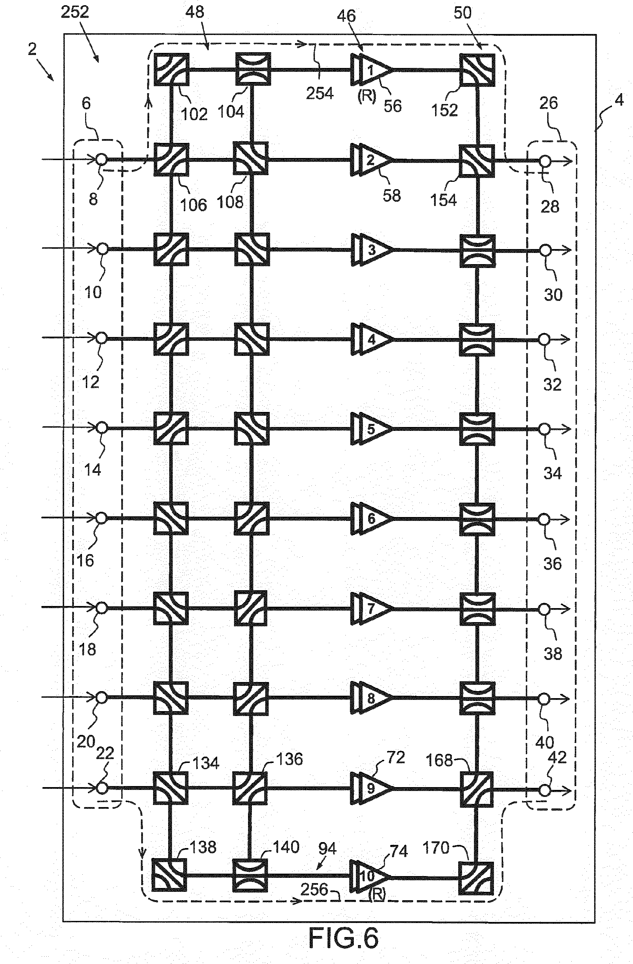

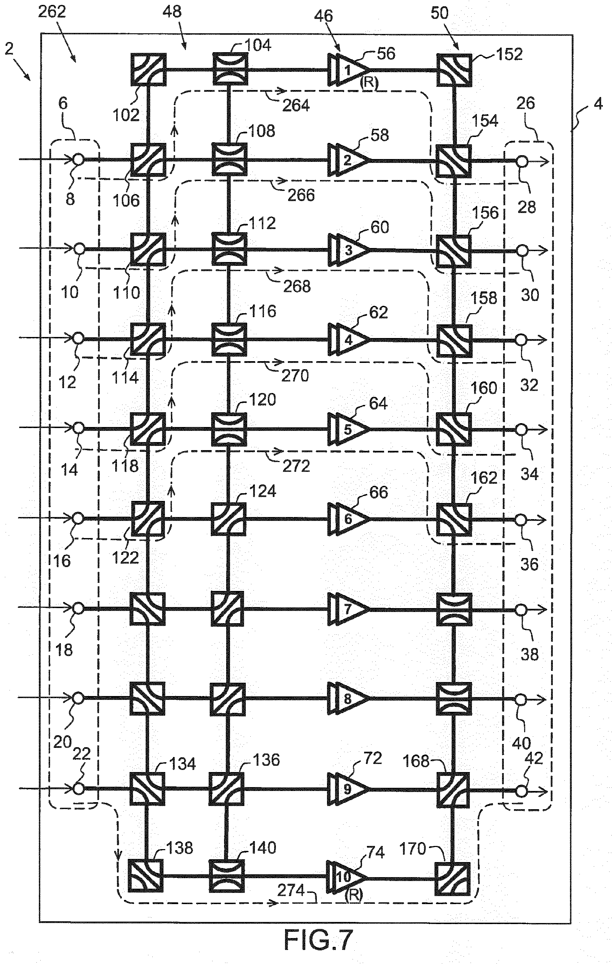

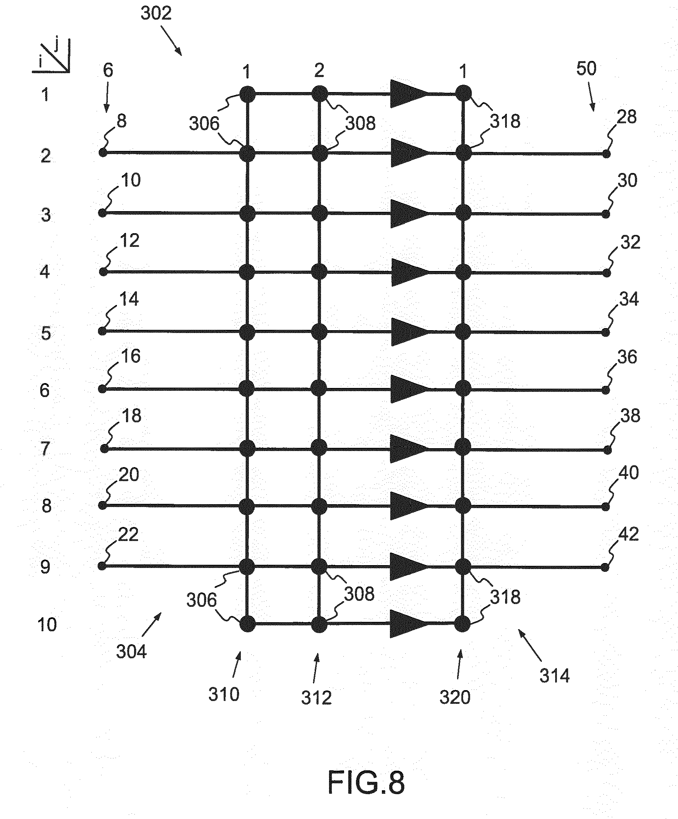

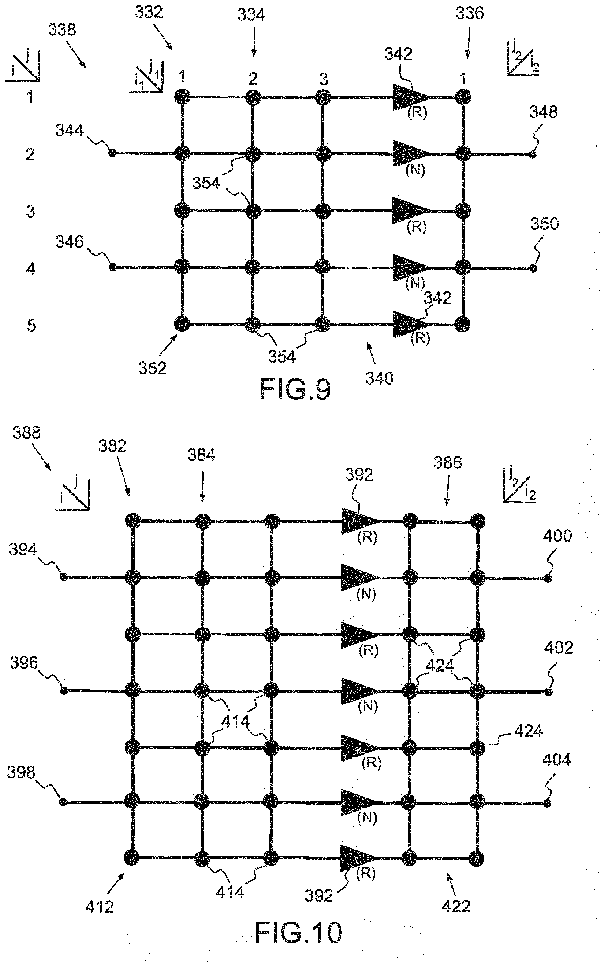

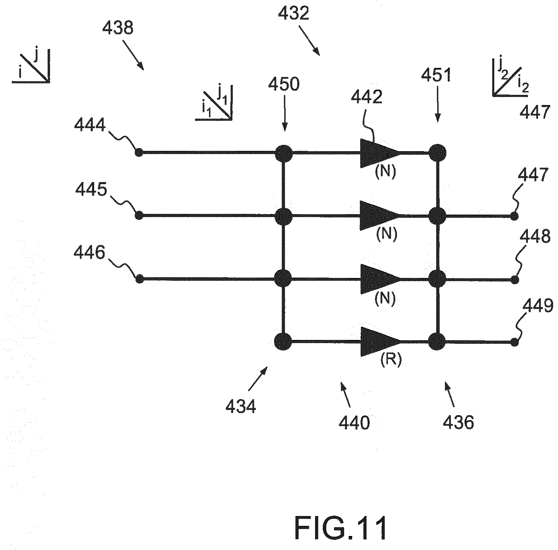

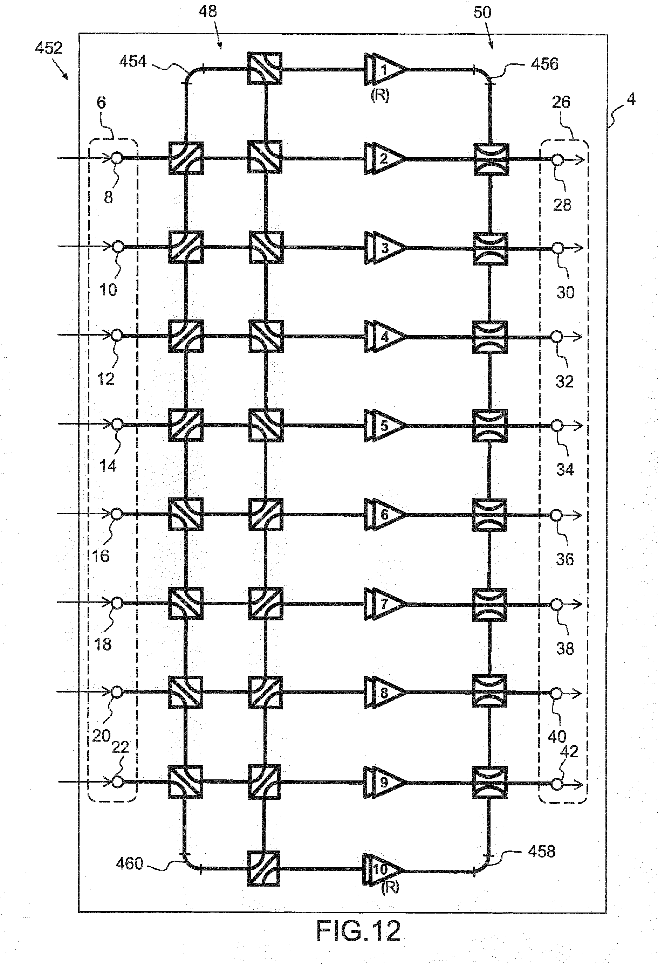

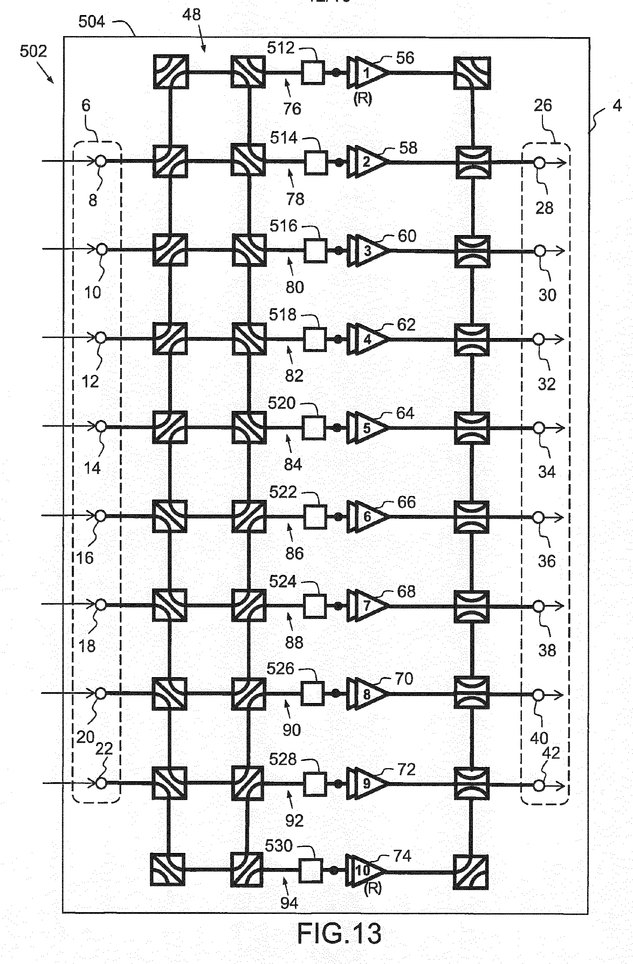

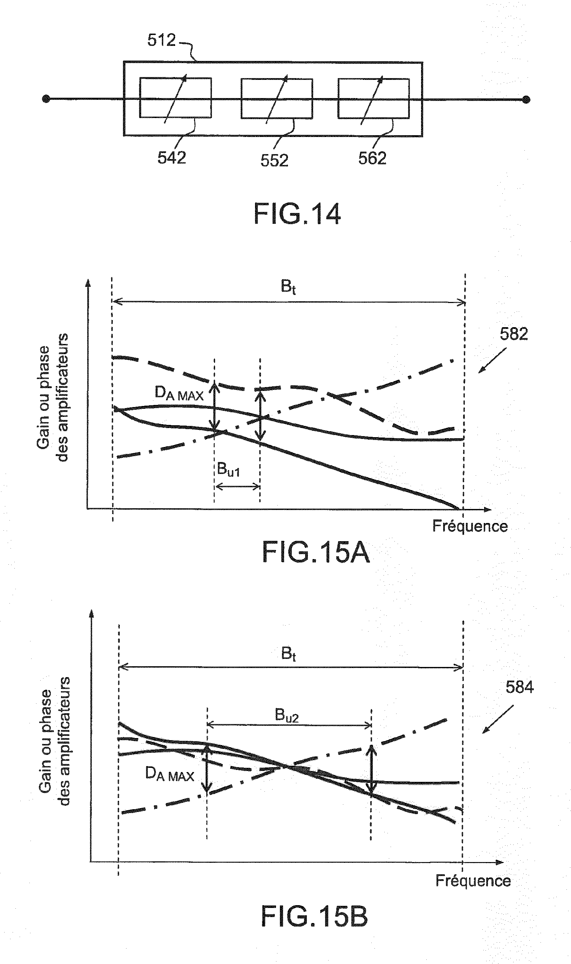

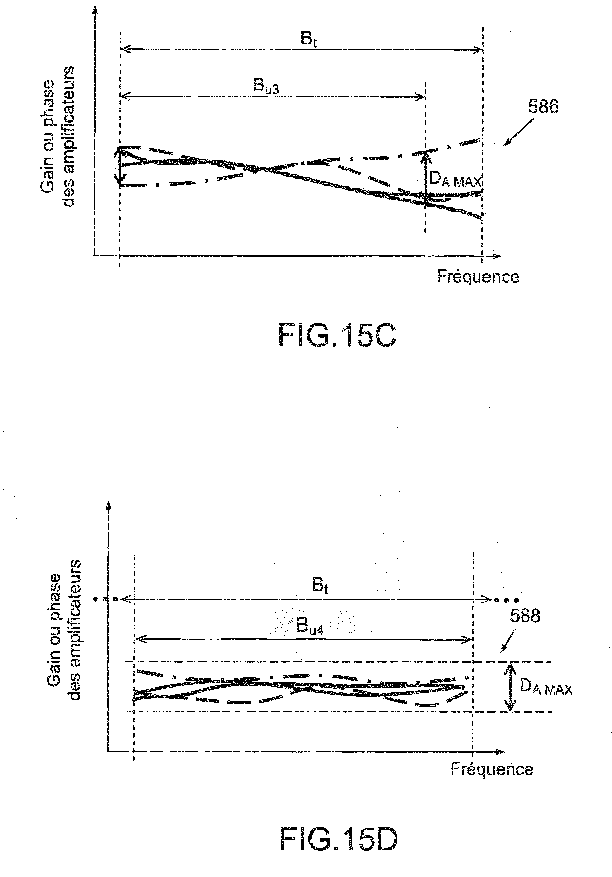

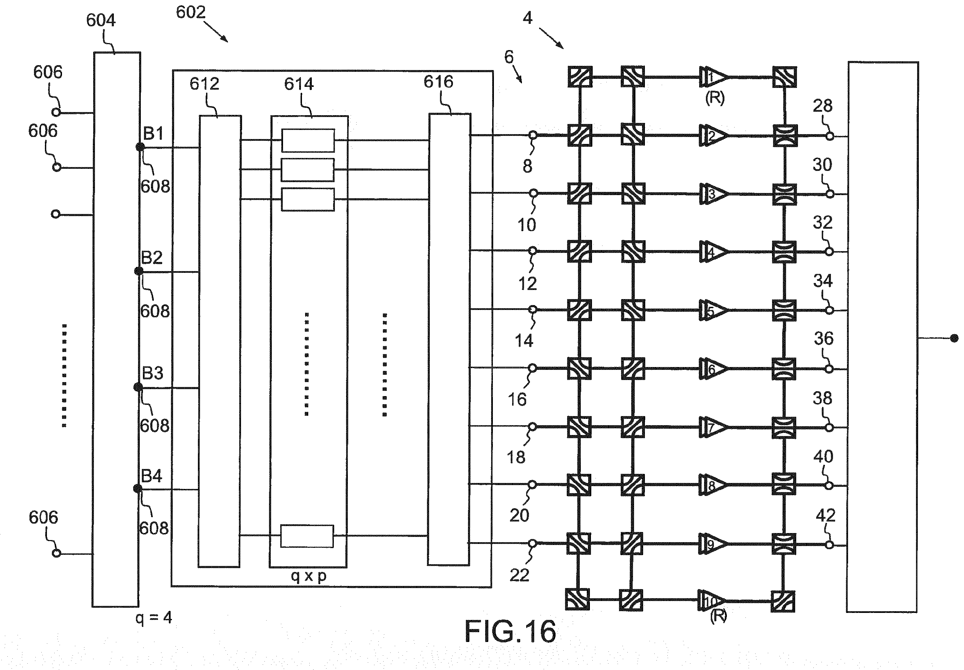

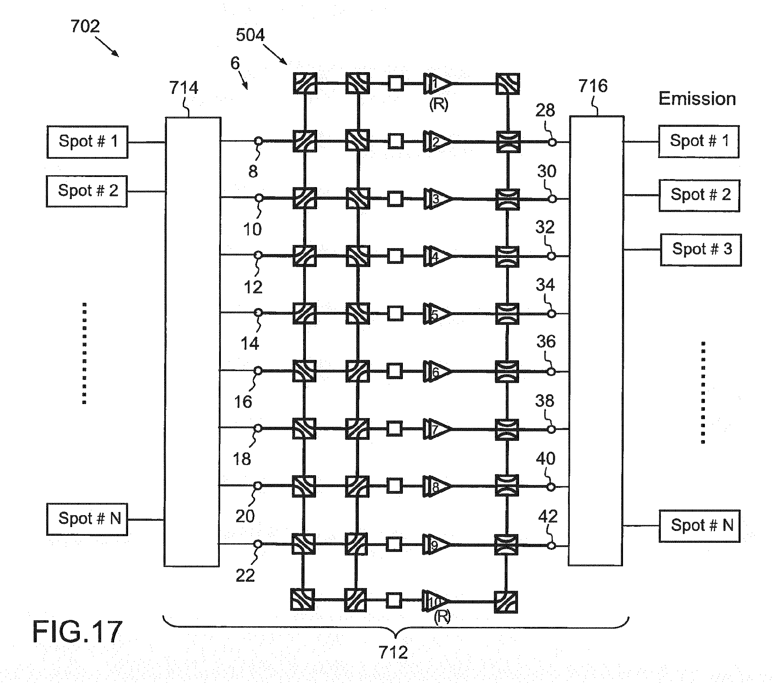

L'invention sera mieux comprise à la lecture de la description de plusieurs formes de réalisation qui va suivre, donnée uniquement à titre d'exemple et faite en se référant aux dessins sur lesquels :
.- la Figure 1 est une vue d'une architecture d'un premier mode de réalisation de dispositif d'amplification répartie selon l'invention dans une configuration de routage nominale d'un réservoir d'amplification ;
.- les Figures 2A, 2B, 2C sont des vues des configurations possibles d'un commutateur tournant quadripolaire d'un anneau de redondance du dispositif d'amplification répartie de la Figure 1 ;
.- la Figure 3 est une vue d'une première configuration de routage de secours du dispositif d'amplification répartie de la Figure 1 correspondant à une panne unique de l'amplificateur de rang 2 ;
.- la Figure 4 est une vue d'une deuxième configuration de routage de secours du dispositif d'amplification répartie de la Figure 1 correspondant à une panne unique de l'amplificateur de rang 9 ;
.- la Figure 5 est une vue d'une troisième configuration de routage de secours du dispositif d'amplification répartie de la Figure 1 correspondant à une panne unique de l'amplificateur de rang 6 ;
.- la Figure 6 est une vue d'une quatrième configuration de routage de secours du dispositif d'amplification répartie de la Figure 1 correspondant à une double panne, celle de l'amplificateur de rang 2 et celle de l'amplificateur de rang 9 ;
.- la Figure 7 est une vue d'une cinquième configuration de routage de secours du dispositif d'amplification répartie de la Figure 1 correspondant à une double panne, celle de l'amplificateur de rang 6 et celle de l'amplificateur de rang 9 ;
.- la Figure 8 est une représentation matricielle des anneaux de redondance d'entrée et de sortie du premier mode de réalisation de dispositif d'amplification répartie selon l'invention de la Figure 1 ;
.- la Figure 9 est une représentation matricielle des anneaux de redondance d'entrée et de sortie d'un deuxième mode réalisation d'un dispositif d'amplification répartie à 5 amplificateurs à deux entrées et deux sorties de réservoir avec une redondance de 3 amplificateurs de secours pour deux amplificateurs nominaux (p égal à 2 et r égal à 3) ;
.- la Figure 10 est une représentation matricielle des anneaux de redondance d'entrée et de sortie d'un troisième mode de réalisation d'un dispositif d'amplification répartie à 7 amplificateurs à trois entrées et trois sorties de réservoir avec une redondance de quatre amplificateurs de secours pour trois amplificateurs nominaux (p égal à 3 et r égal à 4) ;
.- la Figure 11 est une représentation matricielle des anneaux de redondance d'entrée et de sortie d'un quatrième mode de réalisation d'un dispositif d'amplification répartie à 4 amplificateurs à trois entrées et trois sorties de réservoir avec une redondance de quatre amplificateurs de secours pour trois amplificateurs nominaux (p égal à 3 et r égal à 1)
.- la Figure 12 est une vue d'un cinquième mode de réalisation de dispositif d'amplification répartie selon l'invention, dérivé du premier mode de réalisation des Figures 1 à 8 ;
.- la Figure 13 est une vue d'un sixième mode de réalisation de dispositif d'amplification répartie selon l'invention, dérivé du premier mode de réalisation des Figures 1 à 8 avec des moyens d'équilibrage ou d'égalisation en gain et phase des chemins d'amplification répartie ;
.- la Figure 14 est une vue des moyens de réglage d'une voie interne d'amplification répartie du cinquième mode de réalisation de la Figure 12 ;
.- les Figures 15A, 15B, 15C et 15D sont des vues des dispersions en gain et phase des chemins d'amplification répartie d'un dispositif d'amplification répartie classique sur huit amplificateurs actifs (p=8) avec deux amplificateurs de secours (n-p=2) correspondant respectivement à un premier cas de dispositif dépourvu d'égalisation des longueurs électriques des chemins de routage et dépourvu de moyens de réglage en gain et phase, un deuxième cas de dispositif dépourvu d'égalisation des longueurs électriques des chemins de routage et pourvu de moyens de réglage en gain et phase sur une fréquence prédéterminée, un troisième cas de dispositif avec égalisation des longueurs électriques des chemins de routage au sein d'une même configuration et pourvu de moyens de réglage en gain et phase sur une fréquence prédéterminée, et un quatrième cas de dispositif avec égalisation des longueurs électriques des chemins de routage d'une même configuration et pourvu de moyens de réglage en gain et phase sur une bande de fréquences ;
.- la Figure 16 est une vue d'un septième mode de réalisation de dispositif d'amplification répartie selon l'invention, dérivé du premier mode de réalisation des Figures 1 à 8 avec des moyens de regroupement de canaux de communication dans des bandes de fréquence en amont du réservoir d'amplification répartie :
.- la Figure 17 est une vue d'une charge utile de télécommunication, reconfigurable en temps réel en fonction du trafic dans les faisceaux, qui utilise un dispositif à amplification répartie formant un amplificateur de puissance multiport (MPA).

Suivant la Figure 1 et un premier mode de réalisation, un dispositif d'amplification répartie 2, destiné à une charge utile de communications d'un satellite non représentée sur la Figure 1, comprend un réservoir d'amplification radiofréquence RF répartie 4 pour amplifier une première pluralité d'un premier nombre entier p de signaux radiofréquence d'entrée, reçus par un premier port d'entrée 6 de bornes d'entrée 8, 10, 12, 14, 16, 18, 20, 22, identiques entre eux à une phase près et déphasés entre eux suivant une loi de phase prédéterminée, en une deuxième pluralité de p signaux RF amplifiés délivrés par un deuxième port de sortie 26 de bornes de sortie 28, 30, 32, 34, 36, 38, 40 et 42.

Le réservoir d'amplification répartie 4 comporte un ensemble 46 d'un deuxième nombre entier n d'amplificateurs connectés entre un anneau de redondance d'entrée ou amont 48 et un anneau de redondance de sortie ou aval 50, le sens de l'amont vers l'aval étant le sens de parcours d'un signal amplifié réparti depuis une borne d'entrée du port d'entrée vers une borne de sortie au travers d'un amplificateur. Le deuxième nombre entier n amplificateurs est de manière générale supérieur ou égal à 3, et supposé ici à titre d'exemple égal à 10.

Les n amplificateurs de l'ensemble 46, ici au nombre de dix, désignés respectivement par 56, 58, 60, 62, 64, 66, 68, 70, 72 et 74, sont disposés électriquement en parallèle et définissent ou forment respectivement des voies internes ou lignes d'amplification 76, 78, 80, 82, 84, 86, 88, 90, 92 et 94, mutuellement isolées électro-magnétiquement et respectivement numérotées par un indice de ligne i variant de 1 au deuxième nombre entier n du haut vers le bas de la Figure 1.

L'ensemble 46 des dix amplificateurs 56, 58, 60, 62, 64, 66, 68, 70, 72 et 74 est composé d'une première série de p amplificateurs radiofréquence nominaux, formée ici par les huit amplificateurs 58, 60, 62, 64, 66, 68, 70, 72, et d'une deuxième série de n-p amplificateurs de secours, formée ici par les deux amplificateurs 56, 74.

Les huit amplificateurs 58, 60, 62, 64, 66, 68, 70, 72 de la première série sont prévus pour fonctionner dans une configuration nominale du réservoir.

Les deux amplificateurs 56, 74 de la deuxième série sont prévus pour fonctionner dans des configurations de secours du réservoir 4 en cas de panne d'au plus deux amplificateurs de l'ensemble des amplificateurs 56, 58, 60, 62, 64, 66, 68, 70, 72 et 74, les voies internes d'amplification 76, 94 associées respectivement aux deux amplificateurs de secours 56, 74 entourant ici en totalité les voies internes d'amplification 78, 80, 82, 84, 86, 88, 90, 92, associées respectivement aux huit amplificateurs nominaux 58, 60, 62, 64, 66, 68, 70, 72.

Les anneaux de redondance d'entrée et de sortie 48, 50 sont connectés respectivement entre le premier port d'entrée 6 et un troisième port 96 de bornes d'entrée de l'ensemble des amplificateurs 46 et entre un quatrième port 97 de bornes de sortie de l'ensemble des amplificateurs 46 et le deuxième port de sortie 26.

Chaque voie interne d'amplification 76, 78, 80, 82, 84, 86, 88, 90, 92 et 94, définie respectivement par son amplificateur associé 56, 58, 60, 62, 64, 66, 68, 70, 72 et 74, est la ligne d'amplification comprise entre la borne d'entrée dudit amplificateur associé, élément du troisième port 96, et la borne de sortie dudit amplificateur associé, élément du quatrième port 97.

L'anneau de redondance d'entrée 48 est formé par un premier réseau 98 de commutateurs tournants quadripolaires, ici vingt commutateurs tournants 102, 104, 106, 108, 110, 112, 114, 116, 118, 120, 122, 124, 126, 128, 130, 132, 134, 136, 138, 140.

L'anneau de redondance de sortie 50 est formé par un deuxième réseau 148 de commutateurs tournants quadripolaires, ici dix commutateurs tournants 152, 154, 156, 158, 160, 162, 164, 166, 168, 170.

Les anneaux de redondance d'entrée et de sortie 48, 50 sont connectés respectivement entre le premier port d'entrée 6 et le troisième port 96 de bornes d'entrée de l'ensemble 46 des dix amplificateurs et entre le quatrième port 97 de bornes de sortie de l'ensemble 46 des dix amplificateurs et le deuxième port de sortie 26, pour mettre en œuvre une famille de configurations de routage comportant une configuration de routage nominale, illustrée sur la Figure 1, qui utilise les huit amplificateurs nominaux de la première série comme amplificateurs actifs, et une ou plusieurs configurations de routage de secours qui utilisent chacune au moins un des deux amplificateurs de secours parmi les huit amplificateurs actifs sélectionnés dans l'ensemble des dix amplificateurs, et qui sont décrites par exemple dans les Figures 3 à 7.

Les anneaux de redondance d'entrée 48 et de sortie 50 sont topologiquement et géométriquement configurés de sorte que chaque configuration de routage de la famille comporte un ensemble de huit chemins indépendants d'amplification répartie, chaque chemin d'amplification incluant individuellement une borne d'entrée du premier port 6, la borne de sortie du deuxième port 26 associée à la borne d'entrée du premier, un amplificateur actif et son numéro de ligne, des premières liaisons passives connectées en série et traversant au moins trois commutateurs tournants quadripolaires de l'anneau de redondance d'entrée et reliant la borne d'entrée du premier port à la borne d'entrée de l'amplificateur actif, et des deuxièmes liaisons passives connectées en série et traversant au moins un commutateur quadripolaire de l'anneau de redondance de sortie et reliant la borne de sortie de l'amplificateur actif à la borne de sortie du deuxième port, et les longueurs électriques de tous les chemins d'une même configuration de routage de la familles sont égales.

Le nombre total de commutateurs tournants quadripolaires traversés par chaque chemin est supérieur ou égal à 5.

Suivant la Figure 1, le réservoir d'amplification répartie 4 est configuré dans la configuration de routage nominale, définie par p (p=8) chemins, ici les huit chemins 182, 184, 186, 188, 190, 192, 194, 196, 198, représentés en traits pointillés de haut en bas sur la Figure 1.

Le premier chemin 182 part de la borne d'entrée 8 du premier port 6, puis traverse successivement les commutateurs d'entrée 106, 102, 104, 108, l'amplificateur nominal 58, le commutateur de sortie 154, et atteint la borne de sortie 28 du deuxième port.

Le deuxième chemin 184 part de la borne d'entrée 10 du premier port 6, puis traverse successivement les commutateurs d'entrée 110, 106, 108, 112, l'amplificateur nominal 60, le commutateur de sortie 156, et atteint la borne de sortie 30 du deuxième port 26.

Le troisième chemin 186 part de la borne d'entrée 12 du premier port, puis traverse successivement les commutateurs d'entrée 114, 110, 112, 116, l'amplificateur nominal 62, le commutateur de sortie 158, et atteint la borne de sortie 32 du deuxième port 26.

Le quatrième chemin 188 part de la borne d'entrée 14 du premier port, puis traverse successivement les commutateurs d'entrée 118, 114, 116, 120, l'amplificateur nominal 64, le commutateur de sortie 160, et atteint la borne de sortie 34 du deuxième port.

Le cinquième chemin 190 part de la borne d'entrée 16 du premier port, puis traverse successivement les commutateurs d'entrée 122, 126, 128, 124, l'amplificateur nominal 66, le commutateur de sortie 162, et atteint la borne de sortie 36 du deuxième port.

Le sixième chemin 192 part de la borne d'entrée 18 du premier port 6, puis traverse successivement les commutateurs d'entrée 126, 130, 132, 128, l'amplificateur nominal 68, le commutateur de sortie 164, et atteint la borne de sortie 38 du deuxième port 26.

Le septième chemin 194 part de la borne d'entrée 20 du premier port, puis traverse successivement les commutateurs d'entrée 130, 134, 136, 132, l'amplificateur nominal 70, le commutateur de sortie 166, et atteint la borne de sortie 40 du deuxième port 26.

Le huitième chemin 196 part de la borne d'entrée 22 du premier port, puis traverse successivement les commutateurs d'entrée 134, 138, 140, 136, l'amplificateur nominal 72, le commutateur de sortie 168, et atteint la borne de sortie 42 du deuxième port.

Il est à remarquer que lorsque deux chemins différents d'une même configuration traversent un même commutateur tournant quadripolaire, les deux chemins internes de commutation sélectionnés du commutateur tournant relient deux paires de pôles différentes, sont séparés et électro-magnétiquement isolés. Les anneaux de redondance d'entrée et de sortie partagent une même technologie. La même technologie partagée par les anneaux de redondance d'entrée et de sortie 48, 50 est comprise dans l'ensemble formé par la technologie coaxiale, la technologie des guides d'onde.

Cela permet d'éviter par exemple le problème de l'égalisation en large bande des chemins de routage réalisés par l'association d'un anneau d'entrée en technologie coaxiale et d'un anneau de sortie à guide. En effet, les longueurs électriques en guide n'ayant pas d'iso-longueur électrique équivalente en technologie coaxiale dans une bande continue de fréquence (on ne peut égaliser une longueur électrique en guide avec une longueur électrique coaxiale qu'à une seule fréquence), l'utilisation d'une même technologie de routage sur les deux anneaux permet de résoudre ce problème. Dans les applications de puissance où l'utilisation d'un anneau de sortie à guides est nécessaire, cela impliquera d'utiliser la même technologie à guides d'ondes pour l'anneau d'entrée alors que les exigences de puissance incitent à l'utilisation d'une technologie plus légère et moins encombrante.

Ainsi, dans le cas où les amplificateurs sont des tubes à ondes progressives TWTs (en anglais « Travelling Waves Tubes ») et la section de sortie est en guide, l'anneau de redondance d'entrée devient aussi en guide.

De manière générale, les anneaux de redondance d'entrée et de sortie utilisent des technologies, éventuellement différentes, mettant en œuvre des conditions de propagation analogues. Lorsque les technologies utilisées par les anneaux de redondance d'entrée et de sortie sont différentes et mettent en œuvre des conditions de propagation analogues, cela signifie que les commutateurs utilisés par lesdits anneaux présentent des fonctions de transfert similaires ou des réponses dans la bande identique à un facteur d'amplification uniforme près.

Suivant les Figures 2A, 2B, 2C trois configurations de commutation d'un commutateur tournant quadripolaire générique 202, utilisées lors de la mise en œuvre par les anneaux de redondance 48, 50 des configurations de routage prévues du réservoir d'amplification, sont illustrées. Le commutateur tournant quadripolaire générique 202, dénommé parfois dans la littérature « T switch », comporte quatre pôles ou bornes de connexion fixes 204, 206, 208, 210, dénommés respectivement par la suite, premier pôle, deuxième pôle, troisième pôle et quatrième pôle.

Suivant une première configuration de commutation du commutateur tournant 202 représenté sur la Figure 2A et faisant suite à l'envoi d'une première commande de configuration interne au commutateur 202, le premier pôle 204 et le troisième pôle 208 sont interconnectés par une première liaison interne passive conductrice 212 tandis que les deuxième et quatrième pôles sont isolés électriquement au sein du commutateur en étant dépourvus de toute connexion à une liaison conductrice interne.

Suivant une deuxième configuration de commutation du commutateur tournant 202 représentée sur la Figure 2B et faisant suite à l'envoi d'une deuxième commande de configuration interne au commutateur tournant 202, le premier pôle 204 et le quatrième pôle 210 sont interconnectés par une deuxième liaison interne passive conductrice 214 tandis que les deuxième et troisième pôles sont interconnectés par une troisième liaison interne passive conductrice 216.

Suivant une troisième configuration de commutation du commutateur tournant 202 représentée sur la Figure 2C et faisant suite à l'envoi d'une troisième commande de configuration interne au commutateur tournant 202, le premier pôle 204 et le troisième pôle 206 sont interconnectés par une quatrième liaison interne passive conductrice 218 tandis que les troisième et quatrième pôles sont interconnectés par une cinquième liaison interne passive conductrice 220.

Cet ensemble de configurations du commutateur tournant est utilisable pour des schémas de redondance froide et/ou chaude des amplificateurs.

Il est à remarquer qu'une variante de la première configuration de commutation du commutateur tournant représenté sur la Figure 2A existe en cas d'un schéma de redondance froide des amplificateurs dans laquelle l'absence de liaison entre le deuxième pôle et le quatrième pôle est remplacée par une liaison électrique séparée et électro-magnétiquement isolée de première liaison électrique 212.

Les anneaux de redondance d'entrée et de sortie sont topo-logiquement et géométriquement configurés et la configuration nominale est choisie pour que les longueurs électriques de tous les chemins de cette configuration de routage nominale soient égales.

La longueur électrique d'un chemin est ici définie comme la différence des phases cumulées en entrée et en sortie d'une portion de ligne de transmission, comprise entre la borne d'entrée et la borne de sortie du chemin, représentative de la série des liaisons passives comprises entre ces deux bornes, traversée par un signal radioélectrique à une fréquence prédéterminée comprise dans la bande utile de transmission, par exemple à la fréquence centrale. L'effet de l'amplificateur actif n'est pas pris en compte en tant que composant actif, étant supposé que tous les amplificateurs du réservoir soient identiques ou égalisés en amplitude et en phase.

Indépendamment de tous les chemins de la configuration nominale choisie, les commutateurs tournants d'un même chemin sont traversés globalement de la même façon en termes du nombre de commutateurs tournants traversés d'un même chemin et de la répartition numérique des configurations de commutation des commutateurs tournant activées dans ce chemin.

En effet, pour chaque chemin 182, 184, 186, 188, 190, 92, 194, 196, le nombre de commutateur tournants est égal à 5 et les configurations de commutation des commutateurs se répartissent à raison d'une première configuration, deux deuxièmes, deux troisièmes configurations de commutateurs tournants.

Suivant la Figure 3, une première configuration de routage de secours 222 du dispositif d'amplification répartie 2 de la Figure 1 remédie à une panne unique de l'amplificateur 58 de rang 2.

Les chemins de la première configuration de routage de secours sont identiques à ceux de la configuration nominale 172 à l'exception du premier chemin nominal 182 qui est remplacé par un premier chemin de secours 224 propre à la première configuration de secours 222.

Le premier chemin de secours 224 part de la borne d'entrée 8 du premier port 6, puis traverse successivement les commutateurs d'entrée 106, 102, 104, l'amplificateur de secours 58, les commutateurs de sortie 152, 154 et atteint la borne de sortie 28 du deuxième port 26.

Les longueurs électriques de tous les chemins de cette première configuration de routage de secours 222 sont égales entre elles. Elles sont mêmes égales à la longueur électrique des chemins de la configuration nominale 172.

De même, indépendamment de tous les chemins de la première configuration de secours choisie 222, les commutateurs tournants d'un même chemin sont traversés globalement de la même façon en termes du nombre de commutateurs tournants traversés d'un même chemin, ici cinq commutateurs, et de la répartition numérique des configurations de commutation des commutateurs tournants activées dans le chemin qui reste ici celle d'une première configuration (Figure 2A), deux deuxièmes (Figures 2B), deux troisièmes configurations (Figures 2C) d'un commutateur tournant générique 202.

Suivant la Figure 4, une deuxième configuration de routage de secours 232 du dispositif d'amplification répartie 2 de la Figure 1 remédie à une panne unique de l'amplificateur nominal 72 de rang 9.

Les chemins de la deuxième configuration de routage de secours 232 sont identiques à ceux de la configuration de routage nominale 172 à l'exception du huitième chemin nominal 196 qui est remplacé par un huitième chemin de secours 234 propre à la deuxième configuration de secours 232.

Le huitième chemin de secours 234 part de la borne d'entrée 22 du premier port 6, puis traverse successivement les commutateurs d'entrée 134, 138, 140, l'amplificateur 74, les commutateurs de sortie 170, 168 et atteint la borne de sortie 42 du deuxième port 26.

Les longueurs électriques de tous les chemins de cette deuxième configuration de routage de secours 232 sont égales entre elles et même égales à la longueur électrique commune des chemins de la configuration nominale 172.

De même, indépendamment de tous les chemins de la deuxième configuration de secours choisie 232, les commutateurs tournants d'un même chemin sont traversés globalement de la même façon en termes du nombre de commutateurs tournants traversés d'un même chemin, ici cinq commutateurs, et de la répartition numérique des configurations de commutation des commutateurs tournant activées dans ce chemin qui reste ici à l'instar de la configuration de routage nominale 172 du réservoir 2 celle d'une première configuration, deux deuxièmes, deux troisièmes configurations d'un commutateur tournant générique 202.

Suivant la Figure 5, une troisième configuration de routage de secours 242 du dispositif d'amplification répartie de la Figure 1 remédie à une panne unique de l'amplificateur nominal 66 de rang 6.

Les chemins de la troisième configuration de routage de secours 242 sont identiques à ceux de la configuration de routage nominale 172 à l'exception des cinquième, sixième, septième, huitième chemins nominaux 190,192, 194, 196 qui sont remplacés respectivement par les cinquième, sixième, septième, huitième chemins de secours 244, 246, 248, 250 propres à la troisième configuration de secours 242.

Le cinquième chemin de secours 244 part de la borne d'entrée 16 du premier port 6, puis traverse successivement les commutateurs d'entrée 122, 126, 128, l'amplificateur nominal 68, les commutateurs de sortie 164, 162 et atteint la borne de sortie 36 du deuxième port 26.

Le sixième chemin de secours 246 part de la borne d'entrée 18 du premier port 6, puis traverse successivement les commutateurs d'entrée 126, 130, 132, l'amplificateur nominal 70, les commutateurs de sortie 166, 164 et atteint la borne de sortie 38 du deuxième port 26.

Le septième chemin de secours 248 part de la borne d'entrée 20 du premier port 6, puis traverse successivement les commutateurs d'entrée 130, 134, 136, l'amplificateur nominal 72, les commutateurs de sortie 168, 166 et atteint la borne de sortie 40 du deuxième port 26.

Le huitième chemin de secours 248 part de la borne d'entrée 22 du premier port 6, puis traverse successivement les commutateurs d'entrée 134, 138, 140, l'amplificateur de secours 74 les commutateurs de sortie 170, 168 et atteint la borne de sortie 42 du deuxième port 26.

Les longueurs électriques de tous les chemins de cette troisième configuration de routage 242 sont égales entre elles et même égales à la longueur électrique commune des chemins de la configuration nominale 172.

De même, indépendamment de tous les chemins de la troisième configuration de secours choisie 242, les commutateurs tournants d'un même chemin sont traversés globalement de la même façon en termes du nombre de commutateurs tournants traversés d'un même chemin, ici cinq commutateurs, et de la répartition numérique des configurations de commutation des commutateurs tournant activées dans ce chemin qui reste ici celle d'une première configuration, deux deuxièmes, deux troisièmes configurations d'un commutateur tournant générique 202.

Suivant la Figure 6, une quatrième configuration de routage de secours 252 du dispositif d'amplification répartie de la Figure 1 remédie à une double panne, celle de l'amplificateur nominal 58 de rang 2 et celle de l'amplificateur nominal 72 de rang 9.

Les chemins de la quatrième configuration de routage de secours 252 sont identiques à ceux de la configuration de routage nominale 172 à l'exception des premier et huitième chemins nominaux 182, 196 qui sont remplacés respectivement par les premier et huitième chemins de secours 254 et 256, propres à la quatrième configuration de secours 252.

Le premier chemin de secours 254 part de la borne d'entrée 8 du premier port 6, puis traverse successivement les commutateurs d'entrée 106, 102, 104, l'amplificateur de secours 56, les commutateurs de sortie 152, 154 et atteint la borne de sortie 28 du deuxième port 26.

Le huitième chemin de secours 256 part de la borne d'entrée 22 du premier port 6, puis traverse successivement les commutateurs d'entrée 134, 138, 140, l'amplificateur de secours 74, les commutateurs de sortie 170, 168 et atteint la borne de sortie 42 du deuxième port 26.

Les longueurs électriques de tous les chemins de cette quatrième configuration de routage de secours 252 sont égales entre elles et même égales à la longueur électrique commune des chemins de la configuration nominale 172.

De même, indépendamment de tous les chemins de la cinquième configuration de routage de secours choisie 252, les commutateurs tournants d'un même chemin sont traversés globalement de la même façon en termes du nombre de commutateurs tournants traversés d'un même chemin, ici cinq commutateurs, et de la répartition numérique des configurations de commutation des commutateurs tournant activées dans ce chemin qui reste ici celle d'une première configuration, deux deuxièmes, deux troisièmes configurations d'un commutateur tournant générique 202.

Suivant la Figure 7, une cinquième configuration de routage de secours 262 du dispositif d'amplification répartie de la Figure 1 remédie à une double panne, celle de l'amplificateur nominal 66 de rang 6 et celle de l'amplificateur nominal 72 de rang 9.

Les chemins de la cinquième configuration de routage de secours 262 sont identiques à ceux de la configuration de routage nominale 172 à l'exception des premier, deuxième, troisième, quatrième, cinquième et huitième chemins nominaux 182, 184, 186, 188, 190, 196 qui sont remplacés respectivement par les premier, deuxième, troisième, quatrième, cinquième et huitième chemins de secours 264, 266, 268, 270, 272 et 274 propres à la cinquième configuration de secours 262.

Le premier chemin de secours 264 part de la borne d'entrée 8 du premier port 6, puis traverse successivement les commutateurs d'entrée 106, 102, 104, l'amplificateur de secours 56, les commutateurs de sortie 152, 154 et atteint la borne de sortie 28 du deuxième port 26.

Le deuxième chemin de secours 266 part de la borne d'entrée 10 du premier port 6, puis traverse successivement les commutateurs d'entrée 110, 106, 108, l'amplificateur 58, les commutateurs de sortie 154, 156 et atteint la borne de sortie 30 du deuxième port 26.

Le troisième chemin de secours 268 part de la borne d'entrée 12 du premier port 6, puis traverse successivement les commutateurs d'entrée 114, 110, 112, l'amplificateur nominal 60, les commutateurs de sortie 156, 158 et atteint la borne de sortie 32 du deuxième port 26.

Le quatrième chemin de secours 270 part de la borne d'entrée 14 du premier port 6, puis traverse successivement les commutateurs d'entrée 118, 114, 116, l'amplificateur nominal 62, les commutateurs de sortie 158, 160 et atteint la borne de sortie 34 du deuxième port 26.

Le cinquième chemin de secours 272 part de la borne d'entrée 16 du premier port 6, puis traverse successivement les commutateurs d'entrée 122, 118, 120, l'amplificateur nominal 64, les commutateurs de sortie 160, 162 et atteint la borne de sortie 36 du deuxième port 26.

Le huitième chemin de secours 274 part de la borne d'entrée 22 du premier port 6, puis traverse successivement les commutateurs d'entrée 134, 138, 140, l'amplificateur de secours 74, les commutateurs de sortie 170, 168 et atteint la borne de sortie 42 du deuxième port 26.

Les longueurs électriques de tous les chemins de cette cinquième configuration de routage de secours 262 sont égales entre elles et mêmes égales à la longueur électrique commune des chemins de la configuration nominale 192.

Suivant l'architecture du réservoir d'amplification répartie commune à celle décrite dans les Figures 1 à 7, il existe ainsi dans le cas d'une ou deux pannes d'amplificateurs quelconques pris parmi les dix amplificateurs du réservoir 2 un routage, mis en œuvre par les anneaux de redondance, qui permet une amplification répartie sur huit amplificateurs actifs, et pour laquelle les longueurs électriques des chemins d'amplification sont égales. Cette architecture permet même de disposer d'une famille de routage permettant d'utiliser le réservoir à pleine puissance avec au plus deux pannes sur un ou deux amplificateurs quelconque du réservoir et la préservation d'une même longueur des chemins d'amplification indépendante des configurations de routage de la famille des configurations de routage choisies.

Les anneaux de redondance d'entrée et de sortie 48, 50, utilisés dans le premier mode de réalisation du dispositif d'amplification répartie 2, sont configurés pour compenser de manière complémentaire les variations de longueur électrique des chemins d'amplification active modifiés lors d'une reconfiguration de routage du réservoir en couvrant un ensemble de configurations de routage choisies, décrites partiellement dans les Figures 1 à 7, qui garantissent que tous les chemins nominaux et redondant ont des longueurs électriques égales quelle que soit la fréquence au sein d'une même configuration ou de toutes les configurations de routage choisies.

De manière générale, un dispositif d'amplification répartie, destiné à une charge utile de communications d'un satellite, comprend un réservoir d'amplification répartie pour amplifier une première pluralité d'un premier nombre entier p supérieur ou égal à 2 de signaux radioélectriques RF d'entrée à amplifier, reçus par un premier port d'entrée de bornes d'entrée, identiques entre eux à une phase près et déphasés entre eux suivant une loi de phase prédéterminée, en une deuxième pluralité de p signaux RF amplifiés fournis par un deuxième port de sortie de bornes de sortie, associées respectivement aux bornes d'entrée du premier port selon le même ordre. Le réservoir d'amplification répartie comporte en outre :
.- un ensemble d'un deuxième nombre entier n, supérieur à p et inférieur ou égal à 2p+1, d'amplificateurs disposés électriquement en parallèle et définissant respectivement des voies internes d'amplification, mutuellement isolées électro-magnétiquement et égalisés, et respectivement numérotées par un indice de ligne variant de 1 au deuxième nombre entier n, l'ensemble des n amplificateurs étant composé d'une première série de p amplificateurs radiofréquence nominaux et d'une deuxième série de n-p amplificateurs de secours, et
.- un anneau de redondance d'entrée, formé par un premier réseau de commutateurs tournants quadripolaires, et un anneau de redondance de sortie, formé par un deuxième réseau de commutateurs tournants quadripolaires, les anneaux de redondance d'entrée et de sortie étant connectés respectivement entre le premier port d'entrée et un troisième port de bornes d'entrée de l'ensemble des n amplificateurs et entre un quatrième port de bornes de sortie de l'ensemble des n amplificateurs et le deuxième port de sortie, pour mettre en œuvre une famille de configurations de routage comportant une configuration de routage nominale qui utilise les p amplificateurs nominaux de la première série comme amplificateurs actifs, et une ou plusieurs configurations de routage de secours, qui utilisent chacune au moins un des n-p amplificateurs de secours parmi les p amplificateurs actifs sélectionnés dans l'ensemble des n amplificateurs.

Les anneaux de redondance d'entrée et de sortie partagent la même technologie.

Les voies internes d'amplification associées aux n-p amplificateurs de secours entourent en totalité ou enserrent de manière entrelacée les voies internes d'amplification associées aux p amplificateurs nominaux.

Les anneaux de redondance d'entrée et de sortie sont topologiquement et géométriquement configurés de sorte que chaque configuration de routage de la famille comporte un ensemble de p chemins indépendants d'amplification répartie, chaque chemin d'amplification incluant individuellement une borne d'entrée du premier port, la borne de sortie du deuxième port associée à la borne d'entrée du premier, un amplificateur actif et son numéro de ligne, des premières liaisons passives connectées en série et traversant au moins trois commutateurs tournants de l'anneau de redondance d'entrée et reliant la borne d'entrée du premier port à la borne d'entrée de l'amplificateur actif, et des deuxièmes liaisons passives connectées en série et traversant au moins un commutateur de l'anneau de redondance de sortie et reliant la borne de sortie de l'amplificateur actif à la borne de sortie du deuxième port., et les longueurs électriques de tous les chemins d'une même configuration de routage de la deuxième famille sont égales.

Chaque chemin d'amplification traverse un nombre total de commutateurs tournants supérieur ou égal à cinq.

Les anneaux de redondance d'entrée et de sortie sont topo-logiquement et géométriquement configurés et la famille des configurations de routage est choisie de sorte que les longueurs électriques de tous les chemins d'une même configuration de routage de la famille sont égales.

De manière particulière, les anneaux de redondance d'entrée et de sortie sont topo-logiquement et géométriquement configurés et la famille des configurations de routage est choisie de sorte que les longueurs électriques de tous les chemins de toute la famille sont égales.

Suivant la Figure 8, une représentation matricielle 302 des anneaux de redondance d'entrée et de sortie 48, 50 du premier mode de réalisation de dispositif d'amplification répartie selon l'invention de la Figure 1 est illustrée.

Le premier réseau des commutateurs interconnectés de l'anneau de redondance d'entrée 48 est agencé suivant une première matrice 304 dont les éléments sont les commutateurs tournants quadripolaires d'entrée et forment des premiers nœuds 306, 308, arrangés ici suivant deux colonnes 310, 312 et dix lignes, les dix lignes correspondant aux lignes des voies internes d'amplification 76, 78, 80, 82, 84, 86, 88, 90, 92, 94 de la Figure 1.

Huit premiers nœuds nominaux d'extrémité amont, pris parmi les premiers nœuds 306 de la première colonne 310 formant une première colonne d'extrémité amont, sont connectés aux bornes d'entrée 8, 10, 12, 14, 16, 18, 20, 22 du premier port 6 et numérotés suivant un indice de ligne i1 variant de 2 à 9.

Les dix premiers nœuds 308 de la deuxième colonne 312 formant une première colonne d'extrémité aval, pris comme premiers nœuds d'extrémité aval, sont connectés respectivement un à une aux bornes d'entrée des dix amplificateurs et sont numérotés suivant l'indice de ligne i1 variant de 1 à 10.

Le deuxième réseau des commutateurs interconnectés de l'anneau de redondance de sortie 50 est agencé suivant une deuxième matrice 314 dont les éléments sont les commutateurs tournants quadripolaires de sortie et forment des deuxièmes nœuds 318, arrangés suivant une unique colonne de sortie 320 à dix lignes, les dix lignes correspondant aux lignes des voies internes d'amplification avec la même numérotation suivant l'indice de ligne variant de 1 à 10.

Huit deuxièmes nœuds nominaux d'extrémité aval, pris parmi les deuxièmes nœuds 318 de la colonne de sortie 320 formant une deuxième colonne d'extrémité aval, sont connectés en aval aux bornes de sortie 28, 30, 32, 34, 36, 38, 40, 42 du deuxième port 50 et sont numérotés par l'indice i1 de lignes variant de 2 à 9.

Les dix deuxièmes nœuds 318 de la colonne de sortie 320, formant une colonne d'extrémité amont, sont connectés en amont aux bornes de sortie des amplificateurs.

Cette représentation peut être généralisée, par exemple suivant les Figures 9 et 10, à des dispositifs d'amplification répartie ayant des valeurs de n et p différentes et dont le nombre de colonnes de l'anneau de redondance d'entrée est supérieur ou égal à 3 et/ou le nombre de colonnes de l'anneau de redondance de sortie est supérieur ou égal à 2.

De manière générale, le premier réseau des commutateurs interconnectés de l'anneau de redondance d'entrée est agencé suivant une première matrice dont les éléments sont les commutateurs tournants quadripolaires d'entrée et forment des premiers nœuds arrangés suivant au moins deux colonnes et n lignes, les lignes correspondant aux lignes des voies internes d'amplification.

p premiers nœuds d'extrémité amont d'une première colonne d'extrémité amont sont connectés aux bornes d'entrée du premier port, et n premiers nœuds d'extrémité aval d'une première colonne d'extrémité aval sont connectés respectivement un à une aux bornes d'entrée des n amplificateurs.

Le deuxième réseau des commutateurs interconnectés de l'anneau de redondance de sortie est agencé suivant une deuxième matrice dont les éléments sont les commutateurs tournants de sortie et forment des deuxièmes nœuds arrangés suivant au moins une colonne et n lignes, les n lignes correspondant aux lignes des voies internes d'amplification avec la même numérotation,

Lorsque la deuxième matrice comporte au moins deux deuxièmes colonnes, les deuxièmes nœuds nominaux d'extrémité aval d'une deuxième colonne d'extrémité aval sont connectés aux bornes de sortie du deuxième port et n deuxièmes nœuds d'extrémité amont d'une deuxième colonne d'extrémité amont sont connectés en amont respectivement aux bornes de sortie des amplificateurs suivant un même rang de ligne i.

Lorsque la deuxième matrice comporte une unique deuxième colonne, p deuxièmes nœuds d'extrémité aval et amont d'une unique deuxième colonne d'extrémité sont connectés en aval aux bornes de sortie du deuxième port et connectés en amont respectivement aux bornes de sortie des amplificateurs nominaux suivant un même rang i, et r deuxièmes nœuds restant d'extrémité amont sont connectés en amont respectivement aux bornes de sortie des amplificateurs.

Différentes configurations d'anneaux de redondance peuvent être proposées et représentées suivant la représentation matricielle ci-dessus en fonction du schéma de redondance que l'on souhaite pour le dispositif comme par exemple les schémas 11 : 8 ; 12 : 8 ; et 6 :4.

Suivant la Figure 9, une représentation matricielle 332 des anneaux de redondance d'entrée et de sortie 334, 336 d'un deuxième mode réalisation d'un dispositif d'amplification répartie 338 de redondance 5 : 2 est illustrée.

Le dispositif d'amplification répartie 338 inclut un réservoir d'amplification répartie 340 qui comporte un ensemble de cinq amplificateurs 342 dont trois amplificateurs de secours, deux bornes d'entrée 344, 346 de premier port et deux bornes de sortie 348, 350 de deuxième port.

Une première matrice 352 de représentation de l'anneau de redondance d'entrée 334 est une matrice de premiers nœuds 354 à cinq lignes, identifiées par un indice de ligne i1 variant de 1 à 5 de haut en bas sur la Figure 9, et trois colonnes, identifiées par un indice de colonne j1 variant de 1 à 3.

Les premiers nœuds d'extrémité amont des deuxième (i1=2) et quatrième (i1=4) lignes sont respectivement connectées à une borne d'entrée unique et différente 344, 346. Les premiers nœuds d'extrémité aval des deuxième (i1=2) et quatrième (i1=4) lignes sont respectivement connectées à la borne d'entrée d'un amplificateur nominal unique et différent.

Une deuxième matrice 362 de représentation de l'anneau de redondance de sortie est une matrice de deuxièmes nœuds 364 à cinq lignes, identifiées par un indice de ligne i2 variant de 1 à 5 de haut en bas sur la Figure 9, et une unique colonne, identifiées par un indice de colonne j2 égal à 1.

Les deuxièmes nœuds d'extrémité des deuxième (i2=2) et quatrième (i2=4) lignes sont respectivement connectées en aval à une borne de sortie unique et différente 348, 350. Les deuxième nœuds d'extrémité des deuxième (i2=2) et quatrième (i2=4) lignes sont respectivement connectées à la borne de sortie de l'amplificateur nominal ayant le même indice de lignes.

L'architecture proposée dans le deuxième mode de réalisation 338 permet de disposer de configurations de routage équilibrées sur toute la bande de fréquences et sur tous les chemins dans tous les scénarios de pannes possibles allant d'une panne unique à une triple panne.

Suivant les Figures 9 et 10, la deuxième série des n-p amplificateurs de secours est formée d'au moins trois amplificateurs de secours, et les voies internes d'amplification associées respectivement aux amplificateurs de secours entourent de manière entrelacée les voies internes d'amplification associées respectivement aux amplificateurs nominaux.

Suivant la Figure 10, une représentation matricielle 382 des anneaux de redondance d'entrée et de sortie 384, 386 d'un troisième mode de réalisation d'un dispositif d'amplification répartie 388 de redondance 7 : 3 est illustrée.

Le dispositif d'amplification répartie 388 inclut le réservoir d'amplification répartie 390 qui comporte un ensemble de sept amplificateurs 392 dont quatre amplificateurs de secours (.R.), trois bornes d'entrée 394, 396, 398 de premier port et trois bornes de sortie 400, 402, 404 de deuxième port.

Une première matrice 412 de représentation de l'anneau de redondance d'entrée est une matrice de premiers nœuds 414 à sept lignes, identifiées par un indice de ligne i1 variant de 1 à 7 de haut en bas sur la Figure 10, et trois colonnes, identifiées par un indice de colonne j1 variant de 1 à 3.

Les premiers nœuds d'extrémité amont des deuxième (i1=2), quatrième (i1=4), et sixième (i1=6) lignes sont respectivement connectées à une borne d'entrée unique et différente 394, 396, 398. Les premiers nœuds d'extrémité aval des deuxièmes (i1=2), quatrième (i1=4), sixième (i1=6) lignes sont respectivement connectés à la borne d'entrée d'un amplificateur nominal (N) unique et différent.

Une deuxième matrice 422 de représentation de l'anneau de redondance de sortie 386 est une matrice de deuxièmes nœuds 424 à sept lignes, identifiées par un indice de ligne i2 variant de 1 à 7 de haut en bas sur la Figure 10, et à deux colonnes, identifiées par un indice de colonne j2 variant de 1 à 2 de gauche à droite sur la Figure 10.

Les deuxièmes nœuds d'extrémité aval de la deuxième colonne d'extrémité aval (deuxième colonne de l'anneau de redondance de sortie la plus à droite sur la Figure 10) des deuxième (i2=2), quatrième (i2=4), sixième (ii2=6) lignes sont respectivement connectées en aval à une borne de sortie unique et différente 400, 402, 404. Les deuxième nœuds d'extrémité des deuxième (i2=2), quatrième (i2=4), sixième (i2=6) lignes de la deuxième colonne d'extrémité amont (première colonne de l'anneau de redondance de sortie la plus à gauche sur la Figure 10) sont respectivement connectées à la borne de sortie de l'amplificateur nominal ayant le même indice de ligne.

L'architecture proposée dans le troisième mode de réalisation 388 permet de disposer de configurations de routage équilibrées sur toute la bande de fréquences et sur tous les chemins dans tous les scénarios de pannes possibles allant d'une panne unique à une quadruple panne.

Il est à remarquer que même si l'invention peut être appliquée à un nombre total quelconque d'amplificateurs formant le réservoir et à rapport de redondance (n/(n-p)) quelconque, une augmentation du nombre n-p trop forte conduit certes à corriger une multiplicité de pannes mais avec un nombre de commutateurs de plus en plus élevé, et une complexité, une masse voire des pertes radioélectriques rédhibitoires.

Lorsque n est égal à 2p+1, l'inflation du nombre de colonnes des anneaux de redondance a lieu comme le montre les Figures 9 et 10.

Par contre lorsque n est inférieure ou égal 2p, l'inflation du nombre de colonnes cesse et il sera préféré des architectures du réservoir utilisant deux ou trois colonnes pour l'anneau de redondance d'entrée et une unique colonne pour l'anneau de sortie.

Suivant la Figure 11, une représentation matricielle 432 des anneaux de redondance d'entrée et de sortie 434, 436 d'un quatrième mode de réalisation d'un dispositif d'amplification répartie 438 de redondance 4 :3 est illustrée.

Le dispositif d'amplification répartie 438 inclut le réservoir d'amplification répartie 440 qui comporte un ensemble de quatre amplificateurs 442 dont un amplificateur de secours (R), trois bornes d'entrée 444, 445, 446 de premier port et trois bornes de sortie 447, 448, 449 de deuxième port.

Une première matrice 450 de représentation de l'anneau de redondance d'entrée est une matrice uni-colonne de premiers nœuds à quatre lignes, identifiés par un indice de ligne i1 variant de 1 à 4 de haut en bas sur la Figure 11.

Les premiers nœuds des première (i1=1), deuxième (i1=2), troisième (i1=3) lignes sont respectivement connectés en amont à une borne d'entrée de premier port unique et différente, le premier nœud de la quatrième ligne (i1=4) n'étant connecté directement à aucune borne d'entrée du premier port.

Les premiers nœuds des première (i1=1), deuxième (i1=2), troisième (i1=3) lignes sont connectés respectivement en aval à la borne d'entrée d'un amplificateur nominal (N) unique et différent.

Une deuxième matrice de représentation 451 de l'anneau de redondance de sortie est une matrice uni-colonne de deuxièmes nœuds à quatre lignes, identifiés par un indice de ligne i2 variant de 1 à 4 de haut en bas sur la Figure 11.

Les deuxièmes nœuds des deuxième (i2=2), troisième (i2=3), quatrième (i2=4) lignes sont respectivement connectés en aval à une borne de sortie du deuxième port, le deuxième nœud de la première ligne (i2=1) n'étant connecté directement à aucune borne de sortie du deuxième port. Les deuxièmes nœuds des deuxième (i2=2), troisième (i2=3) lignes sont respectivement connectées à la borne de sortie de l'amplificateur nominal ayant le même indice de ligne tandis que le deuxième nœud de la quatrième (i2=4) ligne est connectée à la sortie de l'amplificateur de secours.

Cette configuration peut être généralisée à un nombre p d'amplificateurs quelconque pour fournir un dispositif d'amplification répartie de redondance p+1 : p.

Suivant la Figure 12, un cinquième mode de réalisation d'un dispositif d'amplification répartie 452 est dérivé du dispositif d'amplification répartie 2 des Figures 1, 2 à 7 et en diffère en ce que les quatre commutateurs de « coin » 102, 152, 138, 140 sont remplacés par des liaisons électriques passives 454, 456, 458, 460 ayant respectivement la même longueur électrique que celle du commutateur correspondante.

Ainsi, la liaison passive 454 et la liaison passive 458 ont respectivement la longueur électrique de la liaison interconnectant le quatrième pôle et le troisième pôle et la longueur électrique de la liaison interconnectant le premier pôle et le deuxième pôle d'un commutateur tournant quadripolaire générique 202 lorsqu'il se trouve dans la troisième configuration de commutation décrite à la Figure 2C.

S'agissant de liaison passive 456 et la liaison passive 460, elles ont respectivement la longueur électrique de la liaison interconnectant le premier pôle et le quatrième pôle et la longueur électrique de la liaison interconnectant le deuxième et le troisième pôle d'un commutateur tournant quadripolaire générique 202 lorsqu'il se trouve dans la deuxième configuration de commutation décrite à la Figure 2B.

De manière générale, au moins un commutateur parmi les commutateurs de la première colonne d'extrémité amont de l'anneau de redondance d'entrée et les commutateurs de la deuxième colonne d'extrémité amont de l'anneau de redondance de sortie est remplacé par une liaison de même longueur électrique.

Suivant la Figure 13, un sixième mode de réalisation d'un dispositif d'amplification répartie 502 est dérivé du dispositif d'amplification répartie 2 des Figures 1, 2 à 7 et en diffère par le réservoir d'amplification répartie 504.

Le réservoir d'amplification répartie 504 possède la même structure que celle du réservoir d'amplification répartie 4 de la Figure 1 et en diffère par l'ajout de moyens de réglage en amplitude et phase 512, 514, 516, 518, 520, 522, 524, 526, 528, 530 sur une large bande, disposés respectivement en amont des amplificateurs de puissance 56, 58, 60 62, 64, 66, 68, 70, 72, I74 et en aval de l'anneau de redondance d'entrée 48 sur les voies d'amplification interne 76, 78, 80, 82, 84, 86, 88, 90, 92 et 94.

De manière générale, moyens de réglage en amplitude et phase sont disposés en amont et/ou en aval de chaque amplificateur entre les anneaux de redondance d'entrée et de sortie, de préférence en amont lorsque les amplificateurs sont des amplificateurs de puissance et de préférence en aval lorsque les amplificateurs sont des amplificateurs à faible bruit.

Suivant la Figure 13, les moyens de réglage en amplitude et phase 512, 514, 516, 518, 520, 522, 524, 526, 528, 530 sont configurés pour équilibrer tous les chemins internes d'amplification répartie des configurations de fonctionnement prévues du réservoir dans une large bande de fréquences en y incluant les disparités de propagation sur toute la bande des amplificateurs qui ne sont pas ici a priori équilibrés entre eux.

Suivant les Figure 13 et 14, les moyens de réglage en amplitude et phase de chaque chemin interne d'amplification répartie, par exemple les moyens de réglage en amplitude et phase 512, comprennent de manière générique un atténuateur d'amplitude 542, un premier déphaseur 552 et un deuxième déphaseur 562, chacun de ces trois éléments étant réglables séparément.

Le premier déphaseur 552 est un déphaseur du type « longueur électrique » compris dans l'ensemble formé par les « phase trimmers » pour lesquels le déphasage varie en fonction de la fréquence. Ce sont en général des déphaseurs mécaniques qui sont largement utilisés dans les technologies coaxiales ou à guides d'ondes.

Le deuxième déphaseur 562 est un déphaseur du type « constant » est à déphasage constant sur toute la bande large de fréquences compris dans les diodes pour des utilisations en basse puissance et les ferrites pour des utilisations en haute puissance.

Les réglages du premier déphaseur 552 et/ou du deuxième déphaseur 562 peuvent être fixés une bonne fois pour toute ou reconfigurables par télécommande.

Suivant la Figure 14 et de manière générale, les atténuateurs d'amplitude 542, les premiers déphaseurs 552 et les deuxièmes déphaseurs 562 des moyens de réglage en amplitude et phase 512, 514, 516, 518, 520, 522, 524, 526, 528, 530 sont configurés respectivement au travers de leurs réglages pour équilibrer les gains des amplificateurs sur la large bande de fréquences, rapprocher les variations de phase en fonction de la fréquence sur une large bande de fréquences de tous les chemins internes d'amplification répartie, les amplificateurs y compris, des configurations de fonctionnement prévues du réservoir, et compenser les dispersions des décalages de phases constants introduits par les amplificateurs actifs dans tous les chemins internes d'amplification répartie des configurations de fonctionnement prévues du réservoir.

Il est à remarquer que l'association d'un premier déphaseur et d'un deuxième déphaseur sur chacune des voies internes est nécessaire pour équilibrer les voies internes dans de larges bandes de fréquences.

Suivant la Figure 15A sont illustrées en fonction de la fréquence sur une large bande Bt fixée les dispersions en gain et phase des chemins d'amplification répartie d'un dispositif d'amplification répartie classique sur huit amplificateurs actifs, c'est-à-dire p égal à 8, avec deux amplificateurs de secours, c'est-à-dire n-p égal 2.

Le dispositif d'amplification répartie classique utilise une architecture classique d'anneaux de redondance d'entrée et de sortie, c'est-à-dire dépourvue de compensation en termes de longueur électrique entre l'anneau d'entrée et l'anneau de sortie sur les chemins d'amplification d'une configuration du routage au sein du réservoir et dépourvu de moyens de réglage en gain et phase sur une fréquence prédéterminée.

La dispersion maximale acceptable en gain e/ou phase dans la bande entre les chemins utilisés à chaque fréquence est fixée et désignée par D_{Amax}, et la bande de transmission utile maximale de fréquences pour laquelle la dispersion en gain et/ou phase pour chaque fréquence dans la bande est inférieure ou égale à Da est notée Bu1.

Il apparait que la bande de transmission utile maximale Bu1 correspondant à une architecture classique de dispositif redondé dépourvu de compensation au sein d'anneaux complémentaire et de moyens de réglage à une fréquence prédéterminée est plus petite étroite que la large bande Bt que l'on souhaite obtenir.

Suivant la Figure 15B sont illustrées en fonction de la fréquence sur une large bande Bt fixée les dispersions en gain et phase sur une large bande des chemins d'amplification répartie d'un dispositif d'amplification répartie classique dans lequel les réponses d'amplification des chemins d'amplification ont été égalisées seulement à l'aide de moyens de réglage en gain et phase sur une fréquence prédéterminée.

La dispersion maximale acceptable en gain et/ou phase entre les chemins utilisés à chaque fréquence est fixée à la même valeur D_{Amax} que celle de la Figure 15A et la bande de transmission utile maximale de fréquences pour laquelle la dispersion en gain et/ou phase est inférieure ou égale à D_{Amax} est notée Bu2.

En dépit d'un élargissement de la bande Bu2 par rapport à la bande Bu1 en raison de l'utilisation de moyens de réglage en gain et phase sur une fréquence prédéterminée, la bande Bu2 est néanmoins plus étroite que la large bande Bt que l'on souhaite obtenir.

Suivant la Figure 15C sont illustrées en fonction de la fréquence sur une large bande Bt fixée les dispersions en gain et/ou phase sur une large bande des chemins d'amplification répartie d'un dispositif d'amplification répartie selon l'invention de la Figure 1 dans lequel il existe une compensation en terme de longueur électrique entre l'anneau d'entrée et l'anneau de sortie sur les chemins d'amplification modifiés au sein de chaque configuration du routage au sein du réservoir, et il existe de moyens de réglage en gain et phase large bande pour chaque chemin d'amplification.

La dispersion acceptable en gain et/ou phase entre les chemins utilisés à chaque fréquence est fixée à la même valeur D_{Amax} que celle de la Figure 15A et la bande de transmission utile maximale de fréquences pour laquelle la dispersion en gain et/ou phase est inférieure ou égale à D_{Amax} est notée Bu3.

Il apparait que la bande Bu3 est aussi large que la large bande Bt et ainsi que le premier mode de réalisation du dispositif d'amplification répartie est compatible d'un fonctionnement large bande tel que recherché.

Suivant la Figure 15D sont illustrées en fonction de la fréquence sur une large bande plus grande que la large bande Bt les dispersions en gain et phase sur toute la bande des chemins d'amplification répartie d'un dispositif d'amplification répartie selon le quatrième mode de réalisation de la Figure 12 dans lequel en supplément de la compensation interne des anneaux de redondance entrée et sortie, une égalisation supplémentaire des réponses d'amplification des chemins de routage est réalisée par des moyens de réglage en gain et phase sur une bande de fréquences.

La dispersion acceptable en gain et/ou phase entre les chemins utilisés à chaque fréquence dans la bande est fixée à la même valeur D_{Amax} que celle de la Figure 15A et la bande de transmission utile maximale de fréquences pour laquelle la dispersion en gain et/ou phase est inférieure ou égale à D_{Amax} est notée Bu4.

Il apparait que la bande Bu4 est plus large que large bande Bu3 et ainsi que le quatrième mode de réalisation du dispositif d'amplification répartie est compatible d'un fonctionnement large bande tel que recherché, et même améliore celui obtenu avec le premier mode de réalisation.

Ainsi, les architectures des divers modes de réalisation de l'invention illustrés dans les Figures 1, 3 à 13 permettent un fonctionnement compatible d'une large bande utilisée. Notamment, les divers modes de réalisation permettront de couvrir toute la bande Ku, c'est-à-dire une bande large de 2GHz avec une fréquence centrale sensiblement égal à 11.7GHz, et d'offrir une flexibilité totale du plan de fréquence alloué aux couvertures utilisant l'amplification répartie.

Suivant la Figure 16 et un septième mode de réalisation d'un dispositif d'amplification répartie 602 selon l'invention, dérivé du premier mode de réalisation 2 des Figures 1 à 7 et du dispositif d'amplification répartie avec combinaison de signaux sur quatre bandes de fréquence, décrit dans la demande de brevet WO 2008/017699 A1, le dispositif d'amplification répartie 602 comprend le réservoir d'amplification répartie 4 de la Figure 1 et des moyens de regroupement de canaux de communication 604 dans des bandes de fréquence, lesdits moyens de regroupement 604 étant disposés en amont du réservoir d'amplification répartie 4.

Les moyens de combinaison de bandes de fréquences comportent s entrées 606 pour recevoir s canaux de communications et q sorties 608 pour fournir respectivement des canaux regroupés au sein de q bandes de fréquences en q signaux de bandes de fréquences. Ici, q est pris par exemple égal à quatre et les s canaux de communication sont regroupés au sein de quatre bandes de fréquences adjacentes, désignées par B1, B2, B3, B4 et formant juxtaposées une large bande de fréquences, en quatre signaux de bandes de fréquences.

Le dispositif d'amplification répartie 602 comprend également un ensemble de diviseurs 612 pour diviser en puissance les q signaux de bandes (q=4) sur les p entrées (p=8) du port d'entrée 6 du réservoir d'amplification répartie 4, et des moyens de réglage du gain et de phase 614 correspondant aux p (p=8) amplificateurs sur les q (q=4) bandes de fréquence, et des moyens de sommation 616 sur une large bande des p*q signaux, divisés en bandes et en puissances, en signaux large bande de puissance divisée.

Les moyens de réglage du gain et de la phase 614 comportent p fois q déphaseurs et atténuateurs disposés au sein de l'ensemble de diviseurs sont ici des moyens de réglage de type large bande comme ceux décrits à la Figure 14.

En variante, les moyens de réglage du gain et de la phase sont des moyens de réglage sur une seule fréquence par bande de fréquence.

Suivant la Figure 17, une charge utile de télécommunication 702, reconfigurable en temps réel en fonction du trafic dans les faisceaux, utilise un dispositif à amplification répartie 712 formant un amplificateur de puissance multiport (MPA).

Le dispositif d'amplification répartie 712 formant MPA comporte le réservoir d'amplification répartie 504, décrit dans la Figure 12, avec la caractéristique supplémentaire que les amplificateurs du réservoir 504 sont des amplificateurs de puissance compris dans l'ensemble formé par les amplificateurs utilisant des tubes à ondes progressives (TWTAs) et les amplificateurs à état solide (SSPAs).

Le dispositif d'amplification répartie 712 formant MPA comprend en outre un réseau de division 714 des puissances d'entrée des signaux fournis par un ensemble de spots ou faisceaux de réception sur les bornes d'entrée 8, 10, 12, 14, 16, 18, 20, 22 du port d'entrée 6, et un réseau de combinaison 716 des puissances de sortie réparties également sur les signaux délivrés en les bornes de sortie 28, 30, 32, 34, 36, 38, 40, 42 du port de sortie 26 du réservoir 504 en des signaux de puissance d'entrée répartie sur un ensemble de spot d'émission en fonction de la demande de trafic.

Dans une variante, les amplificateurs du réservoir d'amplification répartie sont des amplificateurs à état solide à faible bruit et le dispositif d'amplification répartie forme l'étage de réception d'une antenne active de réception.

De manière générale, les amplificateurs d'un réservoir tel que décrit ci-dessus dans les Figures 1 à 13 sont des amplificateurs de puissance compris dans l'ensemble formé par les amplificateurs utilisant des tubes à ondes progressives (TWTAs) et les amplificateurs à état solide (SSPAs).

De manière particulière, au moins un amplificateur du réservoir peut être un ensemble d'au moins deux tubes à ondes progressives (TWTAs) associés en parallèle ou d'au moins deux amplificateurs à état solide (SSPAs) associés en parallèle.

## Revendications

1. Dispositif d'amplification répartie, destiné à une charge utile de communications d'un satellite, comprenant un réservoir d'amplification répartie (4 ; 504) pour amplifier une première pluralité d'un premier nombre entier p supérieur ou égal à 2 de signaux radioélectriques (RF) d'entrée à amplifier, reçus par un premier port d'entrée (6) de bornes d'entrée (8, 10, 12, 14, 16, 18, 20, 22), identiques entre eux à une phase près, en une deuxième pluralité de p signaux RF amplifiés fournis par un deuxième port de sortie (26) de bornes de sortie (28, 30, 32, 34, 36, 38, 40, 42), associées respectivement aux bornes d'entrée (8, 10, 12, 14, 16, 18, 20, 22) du premier port d'entrée (6) selon le même ordre,
le réservoir d'amplification répartie (4 ; 504) comportant
.- un ensemble d'un deuxième nombre entier n, supérieur à p et inférieur ou égal à 2p+1, d'amplificateurs (56, 58, 60, 62, 64, 66, 68, 70, 72, 74) disposés électriquement en parallèle et formant respectivement des voies d'amplification (76, 78, 80, 82, 84, 86, 88, 90, 92, 94), mutuellement isolées électro-magnétiquement et égalisées, et respectivement numérotées par un indice de ligne variant de 1 au deuxième nombre entier n, l'ensemble des n amplificateurs (56, 58, 60, 62, 64, 66, 68, 70, 72, 74) étant composé d'une première série de p amplificateurs radiofréquence nominaux (58, 60, 62, 64, 66, 68, 70, 72) et d'une deuxième série de n-p amplificateurs de secours (56, 74),
.- un anneau de redondance d'entrée (48), formé par un premier réseau matriciel (98) de commutateurs tournants quadripolaires (102, 104, 106, 108, 110, 112, 114, 116, 118, 120, 122, 124, 126, 128, 130, 132, 134, 136, 138, 140), et un anneau de redondance de sortie (50), formé par un deuxième réseau matriciel (148) de commutateurs tournants quadripolaires (152, 154, 156, 158, 160, 162, 164, 166, 168, 170),
les commutateurs tournants quadripolaires (102, 104, 106, 108, 110, 112, 114, 116, 118, 120, 122, 124, 126, 128, 130, 132, 134, 136, 138, 140, 152, 154, 156, 158, 160, 162, 164, 166, 168, 170) ayant chacun trois configurations possibles de commutation de commutateur tournant, et
les anneaux de redondance d'entrée et de sortie (48,50) étant connectés respectivement entre le premier port d'entrée (6) et un troisième port (96) de bornes d'entrée de l'ensemble (46) des n amplificateurs et entre un quatrième port (97) de bornes de sortie de l'ensemble des n amplificateurs et le deuxième port de sortie (26), pour mettre en œuvre une famille de configurations de routage comportant une configuration de routage nominale (172) qui utilise les p amplificateurs nominaux de la première série comme amplificateurs actifs, et
une ou plusieurs configurations de routage de secours (222, 232, 242, 252, 262), qui utilisent chacune au moins un des n-p amplificateurs de secours (56, 74) parmi les p amplificateurs actifs sélectionnés dans l'ensemble des n amplificateurs (56, 58, 60, 62, 64, 66, 68, 70, 72) ;
le dispositif d'amplification répartie (4) étant **caractérisé en ce que** :
.- chaque configuration de routage (172, 222, 232, 242, 252, 262) de la famille comporte un ensemble de p chemins indépendants d'amplification répartie, chaque chemin d'amplification incluant individuellement une borne d'entrée du premier port, la borne de sortie du deuxième port associée à la borne d'entrée du premier port, un amplificateur actif et son numéro de ligne, des premières liaisons passives connectées en série, traversant au moins trois commutateurs tournants de l'anneau de redondance d'entrée (48) et reliant la borne d'entrée du premier port à la borne d'entrée de l'amplificateur actif, et des deuxièmes liaisons passives connectées en série, traversant au moins un commutateur de l'anneau de redondance de sortie (50) et reliant la borne de sortie de l'amplificateur actif à la borne de sortie du deuxième port ; et
.- les anneaux de redondance d'entrée et de sortie (48, 50) utilisent une ou des technologies comprises dans l'ensemble formé par la technologie coaxiale, la technologie des guides d'onde et ayant des conditions de propagation analogues ; et
. les anneaux de redondance d'entrée et de sortie (48, 50) sont topo-logiquement et géométriquement configurés de sorte que les longueurs électriques de tous les chemins d'une même configuration de routage de la famille sont égales.

2. Dispositif d'amplification répartie selon la revendication 1, dans lequel les anneaux de redondance d'entrée et de sortie (48, 50) sont topo-logiquement et géométriquement configurés et la famille des configurations de routage (172, 222, 232, 242, 252, 262) est choisie de sorte que les longueurs électriques de tous les chemins de toute la famille sont égales.

3. Dispositif d'amplification répartie selon l'une quelconque des revendications 1 et 2, dans lequel lors d'une reconfiguration d'une première configuration de routage de la famille (172) en une deuxième configuration de routage (222, 232, 242, 252, 262) de la famille, les différences de longueurs électriques issues de la reconfiguration de l'anneau d'entrée (48) sont compensées par la reconfiguration de l'anneau de redondance de sortie (50) pour chaque chemin d'amplification répartie modifié.

4. Dispositif d'amplification répartie selon l'une quelconque des revendications 1 à 3, dans lequel la même technologie est partagée par les anneaux de redondance d'entrée et de sortie (48, 50), et est comprise dans l'ensemble formé par la technologie coaxiale, la technologie des guides d'onde.

5. Dispositif d'amplification répartie selon l'une quelconque des revendications 1 à 4, dans lequel
indépendamment de tous les chemins de toutes les configurations de routage de la famille du réservoir (4),
le nombre de commutateurs tournants traversés de chaque chemin est le même et la répartition numérique des configurations de commutation des commutateurs tournant activées dans chaque chemin est la même.

6. Dispositif d'amplification répartie selon l'une quelconque des revendications 1 à 5, dans lequel
la famille des configurations de routage comporte une configuration de routage nominale qui utilise les p amplificateurs nominaux de la première série comme amplificateurs actifs, et
une ou plusieurs configurations de routage de secours qui utilisent chacune au moins un des n-p amplificateurs de secours parmi les p amplificateurs actifs sélectionnés dans l'ensemble des n amplificateurs;
la ou les configurations de routage de secours étant déterminés pour maintenir une capacité maximale d'amplification du réservoir dans tous les cas de pannes d'au plus p amplificateurs parmi l'ensemble des n amplificateurs lorsque p est inférieur ou égal à n, et d'au plus p+1 amplificateurs parmi l'ensemble des n amplificateurs lorsque n est égal à 2p+1.

7. Dispositif d'amplification répartie selon l'une quelconque des revendications 1 à 6, dans lequel
Le premier réseau (98) des commutateurs interconnectés de l'anneau de redondance d'entrée (48) est agencé suivant une première matrice (304) dont les éléments sont les commutateurs tournants quadripolaires d'entrée et forment des premiers nœuds (306, 308) arrangés suivant au moins deux colonnes et n lignes, les lignes correspondant aux lignes des voies internes d'amplification, p premiers nœuds d'extrémité amont d'une première colonne d'extrémité amont étant connectés aux bornes d'entrée du premier port et n premiers nœuds d'extrémité aval d'une première colonne d'extrémité avale, étant connectés respectivement un à une aux bornes d'entrée des n amplificateurs ; et
Le deuxième réseau (148) des commutateurs interconnectés de l'anneau de redondance de sortie est agencé suivant une deuxième matrice (314) dont les éléments sont les commutateurs tournants de sortie et forment des deuxièmes nœuds (318) arrangés suivant au moins une colonne et n lignes, les n lignes correspondant aux lignes des voies internes d'amplification avec la même numérotation,
p deuxièmes nœuds nominaux d'extrémité aval d'une deuxième colonne d'extrémité aval étant connectés aux bornes de sortie du deuxième port et n deuxièmes nœuds d'extrémité amont d'une deuxième colonne d'extrémité amont, étant connectés en amont respectivement aux bornes de sortie des amplificateurs suivant un même rang i, lorsque la deuxième matrice comporte au moins deux deuxièmes colonnes ; ou
p deuxièmes nœuds d'extrémité aval et amont d'une unique deuxième colonne d'extrémité connectés en aval aux bornes de sortie du deuxième port et connectés en amont respectivement aux bornes de sortie des amplificateurs nominaux suivant un même rang i, et n-p deuxièmes nœuds restant d'extrémité amont connectés en amont respectivement aux bornes de sortie des amplificateurs lorsque la deuxième matrice comporte une unique deuxième colonne.

8. Dispositif d'amplification selon la revendication 7, dans lequel au moins un commutateur (102, 152, 170, 138) parmi les commutateurs de la première colonne d'extrémité amont et de la deuxième colonne d'extrémité amont est remplacé par une liaison (454, 456, 458, 460) de même longueur électrique.

9. Dispositif d'amplification selon l'une quelconque des revendications 7 à 8 dans lequel la première matrice (304) comporte deux ou trois colonnes et la deuxième matrice (314) comporte une unique colonne.

10. Dispositif d'amplification selon l'une quelconque des revendications 1 à 9, dans lequel
le réservoir d'amplification répartie (504) comporte des moyens de réglage en amplitude et phase (512, 514, 516, 518, 520, 522, 524, 526, 528, 530), disposés en amont et/ou en aval de chaque amplificateurs entre les anneaux de redondance d'entrée et de sortie, de préférence en amont lorsque les amplificateurs sont des amplificateurs de puissance et de préférence en aval lorsque les amplificateurs sont des amplificateurs à faible bruit ;
et les moyens de réglage en amplitude et phase (512, 514, 516, 518, 520, 522, 524, 526, 528, 530) sont configurés pour équilibrer tous les chemins internes d'amplification répartie des configurations de fonctionnement prévues du réservoir dans une large bande de fréquences.

11. Dispositif d'amplification selon la revendication 10, dans lequel
les moyens de réglage en amplitude et phase (512, 514, 516, 518, 520, 522, 524, 526, 528, 530) de chaque chemin interne d'amplification répartie comprennent un atténuateur d'amplitude (542), un premier déphaseur (552) et un deuxième déphaseur (562),
le premier déphaseur (552) étant un déphaseur du type « longueur électrique » compris dans l'ensemble formé par les « phase trimmers », et
le deuxième déphaseur (562) étant un déphaseur à déphasage constant sur toute la bande large de fréquences ; et
les atténuateurs d'amplitude, les premiers déphaseurs et les deuxièmes déphaseurs (542, 552, 562) sont configurés respectivement pour équilibrer les gains des amplificateurs sur la large bande de fréquence, rapprocher les variations de phase en fonction de la fréquence sur une large bande de fréquence de tous les chemins internes d'amplification répartie des configurations de fonctionnement prévues du réservoir,
compenser les dispersions des décalages de phases constants introduits par les amplificateurs actifs de tous les chemins internes d'amplification répartie des configurations de fonctionnement prévues du réservoir.

12. Dispositif d'amplification répartie selon l'une quelconque des revendications 1 à 11, dans lequel les amplificateurs du réservoir (504) sont des amplificateurs de puissance compris dans l'ensemble formé par les amplificateurs utilisant des tubes à ondes progressives (TWTAs) et les amplificateurs à état solide (SSPAs), et le dispositif d'amplification répartie est un amplificateur de puissance multiport comportant en outre
.- un réseau d'équi-répartition de la puissance d'entrée (714) sur les bornes d'entrée du port d'entrée (6); et
.- un réseau de répartition de la puissance de sortie (716).

13. Dispositif d'amplification répartie selon la revendication 12, dans lequel le réseau répartiteur de puissance d'entrée (714) est un réseau d'entrée de formation de faisceau et le réseau de répartition de puissance de sortie (716) est un réseau de formation de sortie.

14. Dispositif d'amplification répartie selon l'une quelconque des revendications 1 à 11, dans lequel les amplificateurs du réservoir d'amplification répartie sont des amplificateurs à état solide à faible bruit et l'étage de réception d'une antenne active de réception.

15. Dispositif d'amplification selon l'une quelconque des revendications 1 à 9, comprenant en outre
.- des moyens de combinaison de bandes de fréquences (604) comportant n entrées pour recevoir n canaux de transmission et q sorties pour fournir respectivement des canaux regroupés au sein de q bandes de fréquences en q signaux de bandes de fréquences ;
.- un ensemble de diviseurs (612) pour diviser en puissance les q signaux de bandes sur les p entrées du port d'entrée du réservoir d'amplification ; et
.- des moyens de réglage du gain et de phase (614) correspondant aux p amplificateurs sur les q bandes de fréquence.

16. Dispositif d'amplification selon la revendication 15, dans lequel les moyens de réglage du gain et de la phase (614) comportent p fois q déphaseurs et atténuateurs disposés au sein de l'ensemble de diviseurs.

## Patentansprüche

1. Verteilte Verstärkungsvorrichtung für eine Satellitenkommunikationsnutzlast, umfassend einen verteilten Verstärkungsreservoir (4; 504) zum Verstärken einer ersten Mehrzahl aus einer ersten ganzen Zahl p gleich oder größer als 2 von zu verstärkenden Eingangs-Hochfrequenz-(HF)-Signalen, die von einem ersten Eingangsport (6) von Eingangsanschlüssen (8, 10, 12, 14, 16, 18, 20, 22) empfangen werden, die bis auf eine Phase miteinander identisch sind, in eine zweite Mehrzahl von p verstärkten HF-Signalen, die von einem zweiten Ausgangsport (26) von Ausgangsanschlüssen (28, 30, 32, 34, 36, 38, 40, 42) geliefert werden, die jeweils mit den Eingangsanschlüssen (8, 10, 12, 14, 16, 18, 20, 22) des ersten Eingangsports (6) in der gleichen Reihenfolge assoziiert sind,
wobei das verteilte Verstärkungsreservoir (4; 504) Folgendes umfasst:
- einen Satz aus einer zweiten ganzen Zahl n größer als p und gleich oder kleiner als 2p+1 von Verstärkern (56, 58, 60, 62, 64, 66, 68, 70, 72, 74), die elektrisch parallel geschaltet sind und jeweils gegenseitig elektromagnetisch isolierte und entzerrte Verstärkungskanäle (76, 78, 80, 82, 84, 86, 88, 90, 92, 94) bilden, jeweils durch einen Zeilenindex nummeriert, der von 1 bis zur zweiten ganzen Zahl n variiert, wobei der Satz von n Verstärkern (56, 58, 60, 62, 64, 66, 68, 70, 72, 74) aus einer ersten Reihe von p nominalen Hochfrequenzverstärkern (58, 60, 62, 64, 66, 68, 70, 72) und einer zweiten Reihe von n-p Backup-Verstärkern (56, 74) besteht,
- einen Eingangsredundanzring (48), der durch ein erstes Matrixnetz (98) aus vierpoligen Drehschaltern (102, 104, 106, 108, 110, 112, 114, 116, 118, 120, 122, 124, 126, 128, 130, 132, 134, 136, 138, 140) gebildet wird, und einen Ausgangsredundanzring (50), der durch ein zweites Matrixnetz (148) aus vierpoligen Drehschaltern (152, 154, 156, 158, 160, 162, 164, 166, 168, 170) gebildet wird,
wobei die vierpoligen Drehschalter (102, 104, 106, 108, 110, 112, 114, 116, 118, 120, 122, 124, 126, 128, 130, 132, 134, 136, 138, 140, 152, 154, 156, 158, 160, 162, 164, 166, 168, 170) jeweils drei mögliche Drehschalter-Schaltkonfigurationen haben und die Eingangs- und Ausgangsredundanzringe (48, 50) jeweils zwischen dem ersten Eingangsport (6) und einem dritten Port (96) von Eingangsanschlüssen des Satzes (46) von n Verstärkern und zwischen einem vierten Port (97) von Ausgangsanschlüssen des Satzes von n Verstärkern und dem zweiten Ausgangsport (26) geschaltet sind, um eine Familie von Routing-Konfigurationen zu implementieren, die eine nominale Routing-Konfiguration (172) umfasst, die die nominalen p Verstärker der ersten Serie als aktive Verstärker verwendet, und
eine oder mehrere Backup-Routing-Konfigurationen (222, 232, 242, 252, 262), die jeweils mindestens einen der n-p Backup-Verstärker (56, 74) unter den p aktiven Verstärkern verwendet, die aus dem Satz von n Verstärkern (56, 58, 60, 62, 64, 66, 68, 70, 72) ausgewählt wurden;
wobei die verteilte Verstärkungsvorrichtung (4) **dadurch gekennzeichnet ist, dass**:
- jede Routing-Konfiguration (172, 222, 232, 242, 252, 262) der Familie einen Satz von p unabhängigen verteilten Verstärkungspfaden umfasst, wobei jeder Verstärkungspfad individuell einen Eingangsanschluss des ersten Ports beinhaltet, der Ausgangsanschluss des zweiten Ports mit dem Eingangsanschluss des ersten Ports, einem aktiven Verstärker und seiner Leitungsnummer assoziiert ist, erste passive Verbindungen, die in Reihe geschaltet sind, durch mindestens drei Drehschalter des Eingangsredundanzrings (48) gehen und den Eingangsanschluss des ersten Ports mit dem Eingangsanschluss des aktiven Verstärkers verbinden, und zweite in Reihe geschaltete passive Verbindungen durch mindestens einen Schalter des Ausgangsredundanzrings (50) gehen und den Ausgangsanschluss des aktiven Verstärkers mit dem Ausgangsanschluss des zweiten Ports verbinden; und
- die Eingangs- und Ausgangsredundanzringe (48, 50) eine oder mehrere Technologien verwenden, die in dem durch Koaxialtechnik, Wellenleitertechnik gebildeten und ähnliche Ausbreitungsbedingungen aufweisenden Satz enthalten sind; und
- die Eingangs- und Ausgangsredundanzringe (48, 50) topologisch und geometrisch so konfiguriert sind, dass die elektrischen Längen aller Pfade einer selben Routing-Konfiguration der Familie gleich sind.

2. Verteilte Verstärkungsvorrichtung nach Anspruch 1, wobei die Eingangs- und Ausgangsredundanzringe (48, 50) topologisch und geometrisch konfiguriert sind und die Familie der Routing-Konfigurationen (172, 222, 232, 242, 252, 262) so gewählt ist, dass die elektrischen Längen aller Pfade der gesamten Familie gleich sind.

3. Verteilte Verstärkungsvorrichtung nach einem der Ansprüche 1 und 2, wobei bei einer Umkonfiguration einer ersten Routing-Konfiguration der Familie (172) in eine zweite Routing-Konfiguration (222, 232, 242, 252, 262) der Familie die Unterschiede in den elektrischen Längen aufgrund der Umkonfiguration des Eingangsrings (48) durch die Umkonfiguration des Ausgangsredundanzrings (50) für jeden modifizierten verteilten Verstärkungspfad kompensiert werden.

4. Verteilte Verstärkungsvorrichtung nach einem der Ansprüche 1 bis 3, wobei dieselbe Technologie von den Eingangs- und Ausgangsredundanzringen (48, 50) gemeinsam genutzt wird und in dem Satz enthalten ist, der durch Koaxialtechnologie, Wellenleitertechnologie gebildet wird.

5. Verteilte Verstärkungsvorrichtung nach einem der Ansprüche 1 bis 4, wobei unabhängig von allen Pfaden aller Routing-Konfigurationen der Reservoirfamilie (4) die Anzahl von in jedem Pfad durchlaufenen Drehschalter gleich ist und die numerische Verteilung der Schaltkonfigurationen der in jedem Pfad aktivierten Drehschalter gleich ist.

6. Verteilte Verstärkungsvorrichtung nach einem der Ansprüche 1 bis 5, wobei
die Familie der Routing-Konfigurationen eine nominale Routing-Konfiguration umfasst, die die p nominalen Verstärker der ersten Serie als aktive Verstärker verwendet, und
eine oder mehrere Backup-Routing-Konfigurationen, die jeweils mindestens einen der n-p Backup-Verstärker aus den ausgewählten p aktiven Verstärkern des Satzes von n Verstärkern verwenden;
wobei die Backup-Routing-Konfiguration(en) zum Aufrechterhalten einer maximalen Verstärkungskapazität des Reservoirs in allen Versagensfällen von höchstens p Verstärkern aus dem Satz von n Verstärkern, wenn p gleich oder kleiner als n ist, und von höchstens p+1 Verstärkern aus dem Satz von n Verstärkern, wenn n gleich 2p+1 ist, bestimmt sind.

7. Verteilte Verstärkungsvorrichtung nach einem der Ansprüche 1 bis 6, wobei
das erste Netzwerk (98) von miteinander verbundenen Schaltern des Eingangsredundanzrings (48) in einer ersten Matrix (304) angeordnet ist, deren Elemente die vierpoligen Eingangsdrehschalter sind und erste Knoten (306, 308) bilden, die in mindestens zwei Spalten und n Reihen angeordnet sind, die Reihen den Reihen der internen Verstärkungskanäle entsprechen, wobei p erste stromaufwärtige Endknoten einer ersten stromaufwärtigen Endspalte mit den Eingangsanschlüssen des ersten Ports verbunden sind und n erste stromabwärtige Endknoten einer ersten stromabwärtigen Endspalte jeweils einer nach dem anderen mit den Eingangsanschlüssen der n Verstärker verbunden sind; und
das zweite Netzwerk (148) der miteinander verbundenen Schalter des Ausgangsredundanzrings in einer zweiten Matrix (314) angeordnet ist, deren Elemente die Ausgangsdrehschalter sind und zweite Knoten (318) bilden, die in mindestens einer Spalte und n Reihen angeordnet sind, wobei die n Reihen den Reihen der internen Verstärkungskanäle mit derselben Nummerierung entsprechen,
wobei p zweite nominale stromabwärtige Endknoten einer zweiten stromabwärtigen Endspalte mit den Ausgangsanschlüssen des zweiten Ports verbunden sind und wobei n zweite stromaufwärtige Endknoten einer zweiten stromaufwärtigen Endspalte stromaufwärts jeweils mit den Ausgangsanschlüssen der Verstärker gemäß einem selben Rang i verbunden sind, wenn die zweite Matrix mindestens zwei zweite Spalten aufweist; oder
wobei p zweite stromabwärtige und stromaufwärtige Endknoten einer einzigen zweiten Endspalte stromabwärts mit den Ausgangsanschlüssen des zweiten Ports verbunden sind und stromaufwärts jeweils mit den Ausgangsanschlüssen der nominalen Verstärker gemäß einem selben Rang i verbunden sind, und wobei n-p verbleibende zweite stromaufwärtige Endknoten stromaufwärts jeweils mit den Ausgangsanschlüssen der Verstärker verbunden sind, wenn die zweite Matrix eine einzige zweite Spalte umfasst.

8. Verstärkungsvorrichtung nach Anspruch 7, wobei mindestens ein Schalter (102, 152, 170, 138) unter den Schaltern der ersten stromaufwärtigen Endspalte und der zweiten stromaufwärtigen Endspalte durch eine Verbindung (454, 456, 458, 460) derselben elektrischen Länge ersetzt ist.

9. Verstärkungsvorrichtung nach einem der Ansprüche 7 bis 8, wobei die erste Matrix (304) zwei oder drei Spalten und die zweite Matrix (314) eine einzige Spalte aufweist.

10. Verstärkungsvorrichtung nach einem der Ansprüche 1 bis 9, wobei
das verteilte Verstärkungsreservoir (504) Amplituden- und Phaseneinstellmittel (512, 514, 516, 518, 520, 522, 524, 526, 528, 530) umfasst, die stromaufwärts und/oder stromabwärts jedes Verstärkers zwischen den Eingangs- und Ausgangsredundanzringen angeordnet sind, vorzugsweise stromaufwärts, wenn die Verstärker Leistungsverstärker sind, und vorzugsweise stromabwärts, wenn die Verstärker rauscharme Verstärker sind;
und die Amplituden- und Phaseneinstellmittel (512, 514, 516, 518, 520, 522, 524, 526, 528, 530) zum Ausgleichen aller internen verteilten Verstärkungspfade der vorgesehenen Betriebskonfigurationen des Reservoirs in einem breiten Frequenzband konfiguriert sind .

11. Verstärkungsvorrichtung nach Anspruch 10, wobei
die Amplituden- und Phaseneinstellmittel (512, 514, 516, 518, 520, 522, 524, 526, 528, 530) jedes internen verteilten Verstärkungspfades ein Amplitudendämpfungsglied (542), einen ersten Phasenschieber (552) und einen zweiten Phasenschieber (562) umfassen,
wobei der erste Phasenschieber (552) ein Phasenschieber des Typs "elektrische Länge" ist, der in dem durch die Phasentrimmer gebildeten Satz enthalten ist, und der zweite Phasenschieber (562) ein Phasenschieber mit konstanter Phasenverschiebung über das gesamte breite Frequenzband ist; und
die Amplitudendämpfungsglieder, die ersten Phasenschieber und die zweiten Phasenschieber (542, 552, 562) jeweils zum Ausgleichen der Verstärkungen der Verstärker über das breite Frequenzband konfiguriert sind, Approximieren der frequenzabhängigen Phasenschwankungen über ein breites Frequenzband aller internen verteilten Verstärkungspfade der vorgesehenen Betriebskonfigurationen des Reservoirs, Kompensieren der Dispersionen der konstanten Phasenverschiebungen, die durch die aktiven Verstärker aller internen verteilten Verstärkungspfade der vorgesehenen Betriebskonfigurationen des Reservoirs eingeführt werden.

12. Verteilte Verstärkungsvorrichtung nach einem der Ansprüche 1 bis 11, wobei die Verstärker des Reservoirs (504) Leistungsverstärker sind, die in dem aus Wanderfeldröhrenverstärkern (TWTAs) und Festkörperverstärkern (SSPAs) gebildeten Satz enthalten sind, und die verteilte Verstärkungsvorrichtung ein Multiport-Leistungsverstärker ist, der ferner Folgendes umfasst:
- ein Eingangsleistungs-Gleichverteilungsnetzwerk (714) an den Eingangsanschlüssen des Eingangsports (6); und
- ein Ausgangsleistungsverteilungsnetzwerk (716).

13. Verteilte Verstärkungsvorrichtung nach Anspruch 12, wobei das Eingangsleistungsverteilungsnetzwerk (714) ein Strahlformungseingangsnetzwerk ist und das Ausgangsleistungsverteilungsnetzwerk (716) ein Ausgangsformungsnetzwerk ist.

14. Verteilte Verstärkungsvorrichtung nach einem der Ansprüche 1 bis 11, wobei die Verstärker des verteilten Verstärkungsreservoirs rauscharme Festkörperverstärker und die Empfangsstufe einer aktiven Empfangsantenne sind.

15. Verstärkungsvorrichtung nach einem der Ansprüche 1 bis 9, die ferner Folgendes umfasst:
- Frequenzband-Kombinationsmittel (604) umfassend n Eingänge zum Empfangen von n Übertragungskanälen und q Ausgänge zum jeweiligen Bereitstellen von Kanälen, die innerhalb von q Frequenzbändern zu q Frequenzbandsignalen gruppiert sind;
- einen Satz von Teilern (612) zum Leistungsverteilen der q Bandsignale an den p-Eingängen des Eingangsports des Verstärkungsreservoirs; und
- Verstärkungs- und Phaseneinstellmittel (614), die den p Verstärkern auf den q Frequenzbändern entsprechen.

16. Verstärkungsvorrichtung nach Anspruch 15, wobei die Verstärkungs- und Phaseneinstellmittel (614) p mal q Phasenschieber und Dämpfungsglieder umfassen, die innerhalb der Teileranordnung angeordnet sind.

## Claims

1. A distributed amplification device intended for a communications payload of a satellite, comprising a distributed amplification tank (4; 504) for amplifying a first plurality of a first whole number p, greater than or equal to 2, of input radio-frequency signals (RF) to be amplified, received by a first input port (6) made up of input terminals (8, 10, 12, 14, 16, 18, 20, 22), identical to each other to a nearest phase, into a second plurality of p amplified RF signals supplied by a second output port (26) made up of output terminals (28, 30, 32, 34, 36, 38, 40, 42), respectively associated with the input terminals (8, 10, 12, 14, 16, 18, 20, 22) of the first input port (6) in the same order,
the distributed amplification tank (4; 504) comprising:
- a set of a second whole number n, greater than p and less than or equal to 2p+1, of amplifiers (56, 58, 60, 62, 64, 66, 68, 70, 72, 74) electrically disposed in parallel and respectively forming amplification channels (76, 78, 80, 82, 84, 86, 88, 90, 92, 94), which are mutually electromagnetically isolated and equalised, and respectively numbered by a line index varying from 1 to the second whole number n, the set of n amplifiers (56, 58, 60, 62, 64, 66, 68, 70, 72, 74) being made up of a first series of p nominal radio-frequency amplifiers (58, 60, 62, 64, 66, 68, 70, 72) and of a second series of n-p backup amplifiers (56, 74);
- an input redundancy ring (48), formed by a first matrix network (98) of quadripolar rotary switches (102, 104, 106, 108, 110, 112, 114, 116, 118, 120, 122, 124, 126, 128, 130, 132, 134, 136, 138, 140), and an output redundancy ring (50), formed by a second matrix network (148) of quadripolar rotary switches (152, 154, 156, 158, 160, 162, 164, 166, 168, 170),
the quadripolar rotary switches (102, 104, 106, 108, 110, 112, 114, 116, 118, 120, 122, 124, 126, 128, 130, 132, 134, 136, 138, 140, 152, 154, 156, 158, 160, 162, 164, 166, 168, 170) each having three possible switching configurations for switching the rotary switch; and the input and output redundancy rings (48, 50) being respectively connected between the first input port (6) and a third input port (96) of input terminals of the set (46) of n amplifiers and between a fourth port (97) of output terminals of the set of n amplifiers and the second output port (26), to implement a group of routing configurations comprising a nominal routing configuration (172), which uses the p nominal amplifiers of the first series as active amplifiers; and
one or more backup routing configurations (222, 232, 242, 252, 262), which each use at least one of the n-p backup amplifiers (56, 74) from among the p active amplifiers selected from the set of n amplifiers (56, 58, 60, 62, 64, 66, 68, 70, 72);
the distributed amplification device (4) being **characterised in that**:
- each routing configuration (172, 222, 232, 242, 252, 262) of the group comprises a set of p independent distributed amplification paths, each amplification path individually including an input terminal of the first port, the output terminal of the second port associated with the input terminal of the first port, an active amplifier and its line number, first passive connections connected in series, passing through at least three rotary switches of the input redundancy ring (48) and connecting the input terminal of the first port to the input terminal of the active amplifier, and second passive connections connected in series, passing through at least one switch of the output redundancy ring (50) and connecting the output terminal of the active amplifier to the output terminal of the second port; and
- the input and output redundancy rings (48, 50) use one or more of the technologies included in the set of technologies formed by coaxial technology, waveguide technology and having similar propagation conditions; and
- the input and output redundancy rings (48, 50) are topologically and geometrically configured so that the electrical lengths of all the paths of the same routing configuration of the group are equal.

2. The distributed amplification device according to claim 1, wherein the input and output redundancy rings (48, 50) are topologically and geometrically configured and the group of routing configurations (172, 222, 232, 242, 252, 262) is selected so that the electrical lengths of all the paths of the entire family are equal.

3. The distributed amplification device according to any one of claims 1 and 2, wherein, during a reconfiguration of a first routing configuration of the group (172) into a second routing configuration (222, 232, 242, 252, 262) of the group, the differences in electrical lengths resulting from the reconfiguration of the input ring (48) are compensated by the reconfiguration of the output redundancy ring (50) for each modified distributed amplification path.

4. The distributed amplification device according to any one of claims 1 to 3, wherein the same technology is shared by the input and output redundancy rings (48, 50) and is included in the set of technologies formed by coaxial technology, by waveguide technology.

5. The distributed amplification device according to any one of claims 1 to 4, wherein,
independently of all the paths of all the routing configurations of the group of the tank (4), the number of rotary switches traversed by each path is the same and the digital distribution of the switching configurations of the rotary switches activated in each path is the same.

6. The distributed amplification device according to any one of claims 1 to 5, wherein
the group of routing configurations comprises a nominal routing configuration that uses the p nominal amplifiers of the first series as active amplifiers, and
one or more backup routing configurations that each use at least one of the n-p backup amplifiers from among the p active amplifiers selected from the set of n amplifiers;
the one or more backup routing configurations being determined to maintain a maximum amplification capacity for the tank in all the cases of breakdowns of at most p amplifiers from among the set of n amplifiers when p is less than or equal to n, and of at most p+1 amplifiers from among the set of n amplifiers when n is equal to 2p+1.

7. The distributed amplification device according to any one of claims 1 to 6, wherein
the first network (98) of interconnected switches of the input redundancy ring (48) is arranged as a first matrix (304), the elements of which are the input quadripolar rotary switches and form first nodes (306, 308) arranged in at least two columns and n lines, the lines corresponding to the lines of the internal amplification channels, p first upstream end nodes of a first upstream end column being connected to the input terminals of the first port and n first downstream end nodes of a first downstream end column being respectively connected to the input terminals of the n amplifiers one by one; and
the second network (148) of interconnected switches of the output redundancy ring is arranged as a second matrix (314), the elements of which are the output rotary switches and form second nodes (318) arranged in at least one column and n lines, the n lines corresponding to the lines of the internal amplification channels with the same numbering;
p second downstream nominal end nodes of a second downstream end column being connected to the output terminals of the second port and n second upstream end nodes of a second upstream end column being connected upstream, respectively to the output terminals of the amplifiers in the same row i, when the second matrix comprises at least two second columns; or
p second downstream and upstream end nodes of a single second end column connected downstream to the output terminals of the second port and connected upstream, respectively to the output terminals of the nominal amplifiers in the same row i, and n-p second remaining upstream end nodes connected upstream, respectively to the output terminals of the amplifiers when the second matrix comprises a single second column.

8. The amplification device according to claim 7, wherein at least one switch (102, 152, 170, 138) from among the switches of the first upstream end column and of the second upstream end column is replaced by a connection (454, 456, 458, 460) of the same electrical length.

9. The amplification device according to any one of claims 7 to 8, wherein the first matrix (304) comprises two or three columns and the second matrix (314) comprises a single column.

10. The amplification device according to any one of claims 1 to 9, wherein
the distributed amplification tank (504) comprises amplitude and phase adjustment means (512, 514, 516, 518, 520, 522, 524, 526, 528, 530), disposed upstream and/or downstream of each amplifier between the input and output redundancy rings, preferably upstream when the amplifiers are power amplifiers and preferably downstream when the amplifiers are low-noise amplifiers;
and the amplitude and phase adjustment means (512, 514, 516, 518, 520, 522, 524, 526, 528, 530) are configured to balance all the internal distributed amplification paths of the scheduled operating configurations of the tank in a broad frequency band.

11. The amplification device according to claim 10, wherein
the amplitude and phase adjustment means (512, 514, 516, 518, 520, 522, 524, 526, 528, 530) of each internal distributed amplification path comprise an amplitude attenuator (542), a first phase shifter (552) and a second phase shifter (562),
the first phase shifter (552) being a phase shifter of the "electrical length" type included in the set formed by the "phase trimmers", and the second phase shifter (562) being a phase shifter with constant phase shifting over the entire broad band of frequencies; and
the amplitude attenuators, the first phase shifters and the second phase shifters (542, 552, 562) are respectively configured to balance the gains of the amplifiers over the broad frequency band, bring together the phase variations as a function of the frequency on a broad frequency band of all the internal distributed amplification paths of the scheduled operating configurations of the tank, compensate the dispersions of the constant phase shifts introduced by the active amplifiers of all the internal distributed amplification paths of the scheduled operating configurations of the tank.

12. The distributed amplification device according to any one of claims 1 to 11, wherein the amplifiers of the tank (504) are power amplifiers included in the set formed by the amplifiers using travelling wave tubes (TWTAs) and the solid-state amplifiers (SSPAs), and the distributed amplification device is a multi-port power amplifier further comprising:
- a network (714) for equally distributing the input power over the input terminals of the input port (6); and
- a network (716) for distributing the output power.

13. The distributed amplification device according to claim 12, wherein the input power distribution network (714) is a beam forming input network and the output power distribution network (716) is an output forming network.

14. The distributed amplification device according to one of claims 1 to 11, wherein the amplifiers of the distributed amplification tank are low-noise, solid-state amplifiers and the reception stage of an active reception antenna.

15. The amplification device according to any one of claims 1 to 9, further comprising:
- means (604) for combining frequency bands comprising n inputs for receiving n transmission channels and q outputs for respectively supplying channels consolidated within q frequency bands into q frequency band signals;
- a set of splitters (612) for splitting the power of the q band signals on the p inputs of the input port of the amplification tank; and- means (614) for adjusting gain and phase corresponding to the p amplifiers on the q frequency bands.

16. The amplification device according to claim 15, wherein the gain and phase adjustment means (614) comprise p times q phase shifters and attenuators disposed within the set of splitters.
